# EUROPEAN PATENT APPLICATION

(11) **EP 1 536 462 A1**
(43) Date of publication of application: **01.06.2005**
(21) Application number: 03733427.3
(22) Date of filing: 13.06.2003
(51) Int. Cl.: H01L 21/31, H01L 21/316, C23C 16/42, H05H 1/42

(54) **OXIDE FILM FORMING METHOD AND OXIDE FILM FORMING APPARATUS**

(30) Priority: 14.06.2002 JP 2002174638; 05.07.2002 JP 2002197780; 11.10.2002 JP 2002299710
(71) Applicant: Sekisui Chemical Co., Ltd., Osaka-shi, Osaka-fu 530-0047 (JP)
(72) Inventor: EGUCHI, Yuji, C/O Sekisui Chemical Co., Ltd., Hachioji-shi, Tokyo 192-0906 (JP); NAKAJIMA, Setsuo, C/O Sekisui Chemical Co., Ltd., Hachioji-shi, Tokyo 192-0906 (JP); ITO, Takumi, C/O Sekisui Chemical Co., Ltd., Kyoto-shi, Kyoto 601-8105 (JP); KAWASAKI, Shinichi, C/O Sekisui Chemical Co., Ltd., Hachioji-shi, Tokyo 192-0906 (JP)
(74) Representative: Liedl, Christine
(86) International application number: PCT/JP2003/007548
(87) International publication number: WO 2003/107409

(57) **Abstract**

An apparatus for forming an oxide film on the surface of a substrate S by a CVD method under the pressure conditions close to the atmospheric pressure, comprising: gas supply sources 3A, 3B for supplying process gases of two components, a raw gas (A) comprising a silicon-contained gas such as TMOS, MTMOS or the like, and a reactive gas (B) comprising an oxidizing gas such as O₂, N₂O or the like, and a discharge processing section 1. The process gas (A) is mixed, in the vicinity of the surface of a substrate without discharge processing, with the process gas (B) discharge processed in the discharge processing section 1, whereby in the CVD method under normal pressure, an oxide film which is excellent in membranous and coverage property is formed at a fast film forming speed. More preferably, a H₂O gas discharge processed or not discharge processed is mixed.

## Description

### TECHNICAL FIELD

The present invention relates to an oxide film forming method for forming an oxide film on the surface of a substrate by the chemical vapor deposition method (CVD) under the pressure close to the atmospheric pressure, and an oxide film forming apparatus for carrying out the method.

### BACKGROUND ART

As methods for forming a silicon oxide film (SiO₂) on the surface of a silicon wafer, or a substrate such as an electronic circuit substrate, there have been mainly employed a low pressure plasma CVD method using tetramethoxysilane (TMOS: Si(OCH₃)₄) and oxygen (O₂), and a normal pressure heat CVD method using tetramethoxysilane (TEOS: Si(OC₂H₅)₄) and ozone (O₃). However, in these oxide film forming methods, there were many points to be improved in order to make both membranous and coverage property better.

Considering such points as described, there is disclosed a method for forming a silicon-contained insulating film which is less in content of water, hydrogen, carbon and so on, and which is excellent in coverage property, by mixing a mixed gas of TEOS and a low concentration ozone gas with a high concentration ozone gas on the surface of the substrate as described in Japanese Patent Publication No. 6181/1996 Publication (hereinafter referred to as Patent Reference 1), and or by spraying a mixed gas of TEOS, an ozone gas and a H₂O gas on the surface of the substrate to form a film as described in Japanese Patent Laid-Open No. 306683/1996 Publication (hereinafter referred to as Patent Reference 2).

Further, in Japanese Patent Laid-Open No. 144084/2001 Publication (hereinafter referred to as Patent Reference 3), there is disclosed a method for forming a silicon-contained insulating film which is less in content of water, hydrogen, carbon and so on, and which is excellent in coverage property, by forming TMOS and an oxidizing gas into plasma to form a film.

In the method described in the above Publication, the membranous, coverage property, and film forming speed are controlled by suitably regulating parameters of temperature, pressure, high frequency voltage, flow rate of reactive gas, and so on.

However, since the oxide film forming methods disclosed in the above-described Patent References 1 and 2 employ the normal pressure heat CVD method, there poses a problem that the film forming speed is slow, and the leak current value is large.

On the other hand, since the oxide film forming method disclosed in the above-described Patent Reference 3 is carried out under the low pressure, there poses a problem that equipment for maintaining the medium under the vacuum state is necessary, and in addition, since it requires a long period of time till the vacuum state is obtained, the productivity is poor.

Further, the Patent Reference 3 merely discloses that the method is carried out under the low pressure, and discloses nothing about carrying out under the normal pressure.

So, the present inventors formed, for the purpose of test, TMOS and gas of O₂ extraction into plasma under the normal pressure to form an oxide film, and found that the film forming speed and membranous were improved as compared with the normal pressure heat CVD method using TEOS and gas of O₃ extraction, but still the fully satisfactory results could not be obtained. This is considered because the parameters in case of forming into plasma under the low pressure cannot be applied under the normal pressure as they are. Particularly, it is considered that where a high frequency voltage of hundreds of kHz is applied to an electrode under the normal pressure, it is difficult to make the membranous better and to obstruct the dielectric breakdown of a film.

Incidentally, as methods for forming an oxide film on the surface of a substrate by the plasma CVD method under the normal pressure, there are contemplated (1) a method for plasma-exciting a mixed gas of a raw gas and an oxygen gas, and thereafter spraying it on the substrate to form an oxide film, and (2) a method for mixing an oxygen gas with the plasma excited raw gas, and further plasma-exciting the mixed gas to form an oxide film on the substrate.

However, according to the above-described film forming methods (1) and (2), since a film is formed on the electrode (for generating plasma) itself in the plasma space, the gas is not utilized effectively, and the high film forming speed is not obtained. Further, there is a disadvantage that since a large quantity of adhesives on the electrode is generated, the maintenance spacing becomes shortened.

Furthermore, in the viscous flow area (normal pressure) greatly affected by the gas flow, even if plural kinds of gases plasma-excited separately are simply concentrated and sprayed on the same place, they are separated and flown as the laminar, and therefore, such a method as described cannot be employed without modification.

The present invention has been accomplished in the light of the problems as noted above with respect to prior art, and it is an object of the invention to provide an oxide film forming method capable of forming an oxide film which is excellent in the membranous and coverage property with fast film forming speed even where the oxide film is formed by the CVD method under the normal pressure, and an oxide film forming apparatus for carrying out the method.

It is a further object of the invention to provide an oxide film forming method capable of forming an oxide film with fast film forming speed, and of making the maintenance spacing longer, and an oxide film forming apparatus for carrying out the method.

### DISCLOSURE OF THE INVENTION

It is contemplated that when the raw gas is formed into plasma, it reacts immediately, and therefore it becomes particles of adhesive substance or reactive substance to the electrode during passage of the plasma space to be consumed, thereby lowering the film forming speed, causing impurities to be mixed into the film, and causing the frequent maintenance to be required.

The present inventors have repeatedly done various studies and experiments in order to achieve the aforementioned objects in consideration of the above-described matter also, as a result of which they found that in the plasma CVD method under the normal pressure, TMOS is emitted without charging into the plasma whereas the discharge processed O₂ is separately emitted, and as a consequence TMOS and O₂ are joined in the vicinity of the surface of a substrate and mixed to thereby enable forming an oxide film which is excellent in membranous and coverage property at a fast film forming speed.

If the raw gas is joined with the reactive gas which was formed to be an active species by passing through the plasma space, the reactive gas which was formed to be an active species and the raw gas come into contact to thereby react with each other to carry out film forming, whereby the raw gas is used efficiently for film forming reaction to enable preventing occurrence of the adhesive substance to the electrode or impurities. Accordingly, the oxide film can be obtained at a high film forming speed, and in addition, the maintenance spacing can be made longer.

The present inventors further have repeatedly done various studies and experiments, as a result of which they found that in the plasma CVD method under the normal pressure, TMOS is mixed, without charging into the plasma, with the discharge processed O₂ in the vicinity of the surface of a substrate, and H₂O gas discharge processed or not discharge processed is added, whereby an oxide film which is more excellent in membranous and coverage property can be formed at a fast film forming speed.

It is noted that the detailed reactive mechanism when H₂O is added is not much clear at present, but it is contemplated that the point is that H₂O meets with the active oxygen species to thereby produce OH radical which is said to have a very strong oxidizing force, or that TMOS (including MTMOS (methyl trimethoxy silane: CH₃ Si (OCH₃)₃)) has a SiOCH₃ radical which is very high in reactivity with H₂O.

Paying attention to the matter as described above, the present invention has realized an oxide film forming method and an oxide film forming apparatus capable of forming an oxide film which is excellent in both membranous and coverage property at a high film forming speed by mixing a reactive gas such as O₂ or N₂O discharge processed with a raw gas such as TMOS or MTMOS not discharge processed in the vicinity of the surface of a substrate.

That is, the present invention provides a method for forming an oxide film on the surface of a substrate by a CVD method under the pressure conditions close to the atmospheric pressure, the method comprising: using process gases of two components, a raw gas (A) and a reactive gas (B); and mixing the discharge processed process gas (B) with the process gas (A) not discharge processed in the vicinity of the surface of a substrate.

Further, the present invention provides an apparatus for forming an oxide film on the surface of a substrate by a CVD method under the pressure conditions close to the atmospheric pressure, the apparatus comprising: a process gas supply source for supplying process gases of two components, a raw gas (A) and a reactive gas (B), and a discharge processing section, wherein the discharge processed process gas (B) is mixed with the process gas (A) not discharge processed in the vicinity of the surface of a substrate.

Further, the present invention has realized an oxide film forming method and an oxide film forming apparatus capable of forming an oxide film which is excellent in both membranous and coverage property by mixing a reactive gas such as O₂ or N₂O discharge processed with a raw gas such as TMOS or MTMOS not discharge processed in the vicinity of the surface of a substrate, and adding H₂O gas discharge processed or not discharge processed.

The detailed structures are as given in the following.

That is, the present invention provides a method for forming an oxide film on the surface of a substrate by a CVD method under the pressure conditions close to the atmospheric pressure, the method comprising: using process gases of three components, a raw gas (A), a reactive gas (B) and a H₂O gas (C); and mixing the process gas (B) discharge processed with the process gas (A) and process gas (C) not discharge processed in the vicinity of the surface of a substrate.

Further, the present invention provides a method for forming an oxide film on the surface of a substrate by a CVD method under the pressure conditions close to the atmospheric pressure, the method comprising: using process gases of three components, a raw gas (A), a reactive gas (B) and a H₂O gas (C); and mixing the process gas (B) and the process gas (C) individually discharge processed with the process gas (A) not discharge processed in the vicinity of the surface of a substrate.

Further, the present invention provides a method for forming an oxide film on the surface of a substrate by a CVD method under the pressure conditions close to the atmospheric pressure, the method comprising: using process gases of three components, a raw gas (A), a reactive gas (B) and a H₂O gas (C); and mixing a mixed gas of the discharge processed process gas (B) and process gas (C) with the process gas (A) not discharge processed in the vicinity of the surface of a substrate.

Further, the present invention provides a method for forming an oxide film on the surface of a substrate by a CVD method under the pressure conditions close to the atmospheric pressure, the method comprising: using process gases of three components, a raw gas (A), a reactive gas (B) and a H₂O gas (C); and mixing the discharge processed process gas (B) with a mixed gas of the process gas (A) and process gas (C) not discharge processed in the vicinity of the surface of a substrate.

Further, the present invention provides an apparatus for forming an oxide film on the surface of a substrate by a CVD method under the pressure conditions close to the atmospheric pressure, the apparatus comprising: a process gas supply source for supplying process gases of three components, a raw gas (A), a reactive gas (B) and a H₂O gas (C), and a discharge processing section, wherein the process gas (B) discharge processed in the discharge processing section is mixed with the process gas (A) and process gas (C) not discharge processed in the vicinity of the surface of a substrate.

Further, the present invention provides an apparatus for forming an oxide film on the surface of a substrate by a CVD method under the pressure conditions close to the atmospheric pressure, the apparatus comprising: a process gas supply source for supplying process gases of three components, a raw gas (A), a reactive gas (B) and a H₂O gas (C), and a discharge processing section, wherein the process gas (B) and process gas (C) individually discharge processed in the discharge processing section are mixed with the process gas (A) not discharge processed in the vicinity of the surface of a substrate.

Further, the present invention provides an apparatus for forming an oxide film on the surface of a substrate by a CVD method under the pressure conditions close to the atmospheric pressure, the apparatus comprising: a process gas supply source for supplying process gases of three components, a raw gas (A), a reactive gas (B) and a H₂O gas (C), and a discharge processing section, wherein a mixed gas of the process gas (B) and process gas (C) discharge processed in the discharge processing section are mixed with the process gas (A) not discharge processed in the vicinity of the surface of a substrate.

Further, the present invention provides an apparatus for forming an oxide film on the surface of a substrate by a CVD method under the pressure conditions close to the atmospheric pressure, the apparatus comprising: a process gas supply source for supplying process gases of three components, a raw gas (A), a reactive gas (B) and a H₂O gas (C), and a discharge processing section, wherein the process gas (B) discharge processed in the discharge processing section is mixed with a mixed gas of the process gas (A) and process gas (C) not discharge processed in the discharge processing section in the vicinity of the surface of a substrate.

In the oxide film forming method and apparatus of the present invention, as the raw gas (A), a silicon-contained gas such as TMOS, MTMOS or the like can be used.

Further, as the reactive gas (B), an oxidizing gas such as O₂, N₂O or the like can be used.

In the oxide film forming method and apparatus of the present invention, preferably, the quantity of the process gas (B) out of the process gases used in the CVD method is in excess of 50 weight % of the whole process gas, and the weight ratio between the process gas (A) and said process gas (C) [process gas (A) / process gas (C)] is 1/100 to 1/0.02.

When O₂ or N₂O of the process gas (B) is less than 50 weight %, the membranous lowers. Further, where the weight ratio [process gas (A) / process gas (C)] is less than 1/100, that is, even if the process gas (C) is increased with respect to the process gas (A), the effect for making the membranous better becomes saturated. On the other hand, when the weight ratio [process gas (A) / process gas (C)] is larger than 1/0.02, the effect of enhancement of the membranous does not appear.

In the oxide film forming method and apparatus of the present invention, preferably, the supplying total of the three components of process gases is 1 to 300SLM. When supplying total of the process gases is less than the aforementioned range, the film forming speed becomes slow. Further, when being larger than the aforementioned range, the gas flow is disturbed, failing to obtain even film forming.

In the oxide film forming method and apparatus of the present invention, further, a process gas (D) called a phosphorus-contained gas such as TMP, TEP or the like or a boron-contained gas such as TMB, TEB or the like may be mixed with the process gas (A) for use.

If the phosphorus-contained gas such as TMP, TEP or the like or the boron-contained gas such as TMB, TEB or the like (D) is mixed, a P dope silicon oxide film, a B dope silicon oxide film, and a B, P dope silicon oxide film or the like can be formed. Since these oxide films are able to reduce stress considerably as compared with a non-dope silicon oxide film, they are extremely effective in case of forming a thick film. Further, since the gettering effect of ion is exhibited, they are effective as a protective film also.

In the oxide film forming apparatus of the present invention, preferably, the distance between the discharge processing section and the surface of a substrate placed on a substrate place section is 0.5 to 30 mm.

In the oxide film forming apparatus of the present invention, preferably, alternatively, the structure may be employed such that the substrate place section for placing the substrate and the discharge processing section are moved relatively in one direction or in both directions whereby the substrate can be carried one way or return relatively, a gas emitting port of the process gas not discharge processed is arranged in the midst of the substrate carrying course, and gas emitting ports of the process gas discharged processed are arranged forward and backward with respect to the substrate carrying direction of the first mentioned gas emitting port.

Here, the structure may be employed in which the substrate place section is moved, the structure may be employed in which the discharge processing section is moved, or the structure may be employed in which both of them are moved.

And, the process gas discharge processed emitted from the gas emitting ports arranged forward and backward with respect to the substrate carrying direction may be the same process gas.

In the oxide film forming apparatus of the present invention, preferably, a flow of the joined gas of the reactive gas and raw gas after passage of the plasma space is a gas flow flowing along the surface to be processed.

If doing so, the joined gas performs reaction continuously while being mixed to form a thin film on the surface to be processed of a substrate. Here, the aforementioned flow is produced to thereby secure the time at which the joined gas is mixed and the time necessary for reaction, and since the reaction is carried out just on the side of the substrate, it is to be consumed for the thin film forming preferentially. Accordingly, it is possible to enhance the film forming speed without wasting the metal-contained gas. It is noted that preferably, if the surface to be processed of the substrate is plane, a flow approximately parallel with the plane is prepared.

As a method for realizing the gas flow of the joined gas as described above, there can be mentioned a method for carrying out exhaust control by an exhaust mechanism so that the joined gas forms a gas flow flowing along the surface to be processed of a substrate.

In the oxide film forming method of the present invention, preferably, the total flow rate of the introducing flow rate of the raw gas and reactive gas is approximately the same as the flow rate of the gas flow flowing along the surface to be processed of a substrate. Further, preferably, as the reactive gas, any of oxygen, nitrogen or hydrogen is used.

The oxide film forming apparatus of the present invention is an oxide film forming apparatus using a raw gas and a reactive gas which reacts with the raw gas, the apparatus comprising an electrode for generating a plasma space under normal pressure, a reactive gas supply source for supplying a reactive gas to the plasma space, a metal-contained gas supply source for supplying a raw gas to the place near an emitting port of the reactive gas having passed through the plasma space, and an exhaust mechanism for exhaust controlling the direction in which the joined gas of the reactive gas having passed through the plasma space and the raw gas flows.

According to the oxide film forming apparatus of the present invention, the raw gas is joined with the reactive gas which passes through the plasma space to thereby be an active species, and the active species and the raw gas come into contact to thereby react each other to form a film, and therefore, the raw gas is used efficiently for film forming reaction, to enable preventing occurrence of adhesives to the electrode or impurities. Accordingly, the oxide film can be obtained at a high film forming speed, and in addition, the maintenance spacing can be made longer.

Further, the exhaust control is carried out so that the direction in which the joined gas flows is the direction along the surface to be processed of a substrate, whereby the joined gas carries out reaction continuously while being mixed to form a thin film on the surface to be processed of a substrate. Here, the above-described flow is produced to thereby secure the time at which the joined gas is mixed and the time necessary for reaction, and since the reaction is carried out just on the side of the substrate, it is to be consumed for formation of a thin film preferentially. The film forming speed can be enhanced without wasting the raw gas. If the surface to be processed is plane, preferably, a flow approximately parallel with the plane is produced.

In the oxide film forming apparatus of the present invention, preferably, the exhaust mechanism is arranged on the side close to the plasma space on the side at a distance of a flow passage of the joined gas (a flow passage along the surface to be processed of a substrate) from a place where the reactive gas having passed through the plasma space and the raw gas are joined.

By the arrangement as described, in comparing a flow prepared by a reactive gas activated through the plasma space with a flow prepared by a raw gas not activated, a flow of the activated gas is short, and the active species comes in contact and mixes with the flow of the raw gas, after which it arrives at the surface to be processed. This arrangement is effective for causing the activated gas to arrive at the surface of a substrate while placing it in contact with the raw gas without losing activity.

In the arrangement of the exhaust mechanism as described above, there is also contemplated the case where winding of external air from the side on which the exhaust mechanism is not provided. To prevent this, there may be employed the structure in which the exhaust mechanisms are arranged on both sides of the joined place, and the conductance of a flow passage on the side near the plasma space, that is, on the side near the gas emitting port of the reactive gas, out of the joined gas flow passages from the joined place to the exhaust mechanisms, is large. In this manner, a conductance difference is prepared between two flow passages, and the flow passage on the side near the plasma space is made to be a main flow, whereby the active species comes in contact and mixes with the flow of the raw gas, and then arrives at the surface to be processed.

The oxide film forming apparatus of the present invention is an oxide film forming apparatus using a raw gas and a reactive gas which reacts with the raw gas, the apparatus comprising a reactive gas supply source having two sets of electrodes for generating plasma spaces under normal pressure and supplying the reactive gas to the respective plasma spaces, and a raw gas supply source for supplying a raw gas between two emitting ports for emitting the reactive gas having passed through the two plasma spaces. Preferably, the two plasma spaces are made to be symmetrical, and the reactive gas supplying quantities are made to be equal.

According to the oxide film forming apparatus of the present invention, emitting ports of reactive gas formed into plasma are arranged on both ends of the raw gas whereby the prevention of winding of external air and the fact that the active species comes in contact and mixes with the flow of the raw gas and then arrives at the surface to be processed may be consistent each other. That is, by the arrangement as described above, the winding of external air is prevented by the gas flow to be extruded naturally, and the active species comes in contact and mixes with the flow of the raw gas and then arrives at the surface to be processed.

In the oxide film forming apparatus of the present invention, when the exhaust mechanisms are arranged on both sides at a distance of the flow passage of the joined gas from the two reactive gas emitting ports, it is possible to control the gas flow along the surface to be processed positively, and to recover the reactive gas after reaction.

In each oxide film forming apparatus of the present invention, the gas flow regulating plate may be provided so as to form the joined gas flow along the surface to be processed of the substrate.

Further, there can be also employed the structure in which the inert gas is emitted from the gas flow regulating plate using the ceramic porous gas flow regulating plate. Since the mixed gas after joining comes in contact with the gas flow regulating plate, the adhesion of a reactant tends to occur, but the inert gas is emitted from the gas flow regulating plate, which is effective for preventing such an adhesion as described. As the inert gas, there can be mentioned nitrogen, argon, helium or the like.

The oxide film forming method and apparatus of the present invention having the aforementioned features can be utilized effectively to form a silicon-contained insulating film (a silicon oxide film) in a semiconductor device.

In the following, the oxide film forming method and oxide film forming apparatus of the present invention will be described in more detail.

The pressure close to the atmospheric pressure termed in the present invention means pressure of 1.0 x 10⁴ to 11 x 10⁴ Pa, but particularly, pressure of 9.331 x 10⁴ to 10.397 x 10⁴ Pa, where the adjustment of pressure is easy and the structure of apparatus is simple, is preferable.

In the present invention, when the oxide film is formed, the substrate is heated and held at a fixed temperature in advance, but preferably, its heating temperature is 100 to 500 °C.

As the discharge processing section used in the present invention, there can be mentioned a discharge device in which an electric field is applied between a pair of electrodes to thereby generate a glow discharge plasma, or the like.

As material for the electrode, there can be mentioned, for example, metallic simple substances such as iron, copper or aluminum, alloys such as stainless steel or brass, metal compounds, or the like.

As the form of electrodes, preferably, there can be mentioned the form in which the distance of the plasma space (between electrodes) is constant for preventing an arc discharge caused by the field concentration from generating, particularly, flat plate-type electrodes are arranged oppositely in parallel.

Further, with respect to the electrodes (opposite electrodes) for generating plasma, it is necessary that a solid dielectric be arranged at least on one opposite surface out of a pair. At this time, preferably, the solid dielectric is in close contact with the electrode on the side to be installed, and the opposite surface of the contacting electrode is completely covered. When there exists a part in which the electrodes are directly opposed without being covered by the solid dielectric, an arc discharge tends to occur therefrom.

The shape of the solid dielectric may be any of plate, sheet or film. Preferably, the thickness of the solid dielectric is 0.01 to 4 mm. When the thickness of the solid dielectric is too thick, a high voltage is sometimes required to generate the discharge plasma, and when the thickness is too thin, the insulating breakdown occurs when voltage is applied to generate an arc discharge sometimes.

It is noted that the solid dielectric may be a film coated on the electrode surface by thermal spraying.

As the materials for the solid dielectric, there can be mentioned for example, plastics such as polytetrafluoroethylene or polyethyleneterephtalate, glass, metal oxides such as silicon dioxide, aluminum oxide, zirconium dioxide or titanium dioxide, and double oxides such as titanium acid barium.

Further, preferably, for the solid dielectric, the dielectric constant is 2 or more (under the environment of 25 °C, thereafter referred to the same). As the concrete examples of the solid dielectric whose dielectric constant is 2 or more, there can be mentioned polytetrafluoroethylene, glass, metal oxide film or the like. Further, for generating a high-density discharge plasma in a stabilized manner, a solid dielectric whose dielectric constant is 10 or more is preferably used. The upper limit of the dielectric constant is not particularly limited, but about 18,500 is known in the actual material. As the solid dielectric whose dielectric constant is 10 or more, there can be mentioned for example, something made of a metal oxide film mixed in 5 to 50 weight % of oxide titanium and 50 to 95 weight % of oxide aluminum, or oxide zirconium-contained metal oxide film.

The distance between the opposite electrodes is suitably determined in consideration of the thickness of the solid dielectric, the magnitude of the applied voltage, the purpose of making use of a plasma or the like, but 0.1 to 50 mm, particularly, 0.1 to 5 mm is preferable. When the distance between the electrodes is not more than 0.1 mm, it is difficult to form a spacing between the electrodes to install them, whereas when exceeding 5 mm, it is difficult to generate the discharge plasma evenly. More preferably, the distance is 0.5 to 3 mm, in which case, the discharge tends to be stabilized.

A voltage such as a high frequency wave, a pulse wave, a microwave or the like is applied between the electrodes to generate a plasma. Preferably, the pulse voltage is applied, and particularly, preferably, a pulse voltage whose rising time and falling time of a voltage are not more than 10 µs, particularly not more than 1 µs, is applied. When exceeding 10 µs, the discharge state tends to shift to the arc discharge, resulting in the unstable so that the high density plasma state by the pulse voltage is hard to be held.

Further, the shorter rising time and falling time, the electrolytic dissociation of gas at the time of plasma generation is carried out efficiently, but the realization of the pulse voltage whose rising time is not more than 40 ns is actually difficult. More preferable range of the rising time and falling time is 50 ns to 5 µs.

The rising time termed herein is time in which the absolute value of a voltage continuously increases, and the falling time termed herein is time in which the absolute value of a voltage continuously decreases.

Preferably, the field strength by the pulse voltage is 1 to 1000 kV/cm, particularly, 20 to 300 kV/cm. When the field strength is not more than 1 kV/cm, it takes much time for the film forming processing, and when exceeding 1000 kV/cm, the arc discharge tends to generate.

Preferably, the current density by the pulse voltage is 10 to 500 mA/cm², particularly, 50 to 500 mA/cm².

Preferably, the frequency of the pulse voltage is not less than 0.5 kHz. When being not more than 0.5 kHz, the plasma density is low, and therefore, it takes much time for the film forming processing. The upper limit is not particularly limited, but even the high frequency band such as 13.56 MHz normally used, or 500 MHz used for the purpose of test will suffice. Considering the easiness of taking consistency with respect to a load or the handling property, a preferable band is not more than 500 kHz. By applying such a pulse voltage as described, it is possible to greatly enhance the processing speed.

Continuous time of 1 pulse in the above-described pulse voltage is preferably not more than 200 µs, more preferably, 0.5 to 200 µs*.* When exceeding 200 µs, it tends to shift to the arc discharge, resulting in the unstable state. The continuous time of 1 pulse termed herein is ON time in which 1 pulse continues in a pulse voltage for which ON/OFF is repeated.

Further, the spacing of the continuous time is 0.5 to 1000 µs, particularly preferably, 0.5 to 500 µs.

As the process gas used in the present invention, a process gas of at least two components, a raw gas (A) and a reactive gas (B) is essential. More preferably, a H₂O gas (C) is added to constitute 3 components.

As the raw gas (A), there can be used metal-contained gases such as silicon-contained gases such as TMOS, MTMOS or the like, Ti gases such as TiCl₂, Ti (O-i-C₃H₇)₄, or such as Al gases Al(CH₃)₃, Al(O-i-C₃H₇)₃, Al (O-Sec- C₄H₉)₃.

Further, as the reactive gas (B), there can be used oxidizing gases such as O₂, and N₂O, nitrogen, hydrogen.

Any of these raw gas (A), reactive gas (B) and H₂O gas (C) may be diluted by a dilute gas for use. Particularly, TMOS, MTMOS, and H₂O are liquid under the normal temperature and normal pressure, and therefore, preferably, they are vaporized by heating or the like, after which the dilute gas is introduced as a carrier gas.

As the dilute gas, there can be used, for example, dilute gases such as nitrogen (N₂) or argon (Ar), helium (He) and the like.

If the gas producing system is bubbling, they are diluted naturally.

In the present invention, preferably, out of the whole process gas used in the CVD method, the reactive gas (B) is more than 50 weight %, and the weight ratio between the raw gas (A) and the H₂O gas (C) (raw gas (A) / H₂O gas (C)) is 1/100 to 1/0.02.

In the present invention, preferably, the total quantity (supply total) of process gases including the dilute gas (except gas used in the CVD method; gas for regulating atmosphere or the like) is 1 to 300 SLM, for example, where an object is from a 2.3-inch wafer to a substrate of 1200 mm□.

Further, the process gas (D) such as phosphorous-contained gas such as TMP (trimethylphosphate : PO(OCH₃)₃), TEP (trimetherlphosphate : PO (OCH₂CH₃)₃) or the like, or boron-contained gases such as TMB (trimethylbolate : B(OCH₃)₃), TEB (triethetherbolate : B(OCH₂CH₃)₃) or the like may be mixed with the process gas (A) for use.

If the phosphorous-contained gas such as TMP, TEP or the like, or the boron-contained gas (D) such as TMB, TEB or the like is mixed, a P dope silicon oxide film, a B dope silicon oxide film, a B, P dope silicon oxide film or the like can be formed. These oxide films are extremely effective where a thick film is formed, because the stress can be reduced considerably as compared with a non-dope silicon oxide film. Further, they are extremely effective as a protective film because the gettering effect of ion is exhibited.

According to the present invention, the discharge can be generated under the atmospheric pressure directly between the electrodes, and the high speed processing can be realized by the more simplified electrode construction, the atmospheric pressure plasma apparatus according to the discharge procedure, and the processing procedure. Further, the parameters relating to each of thin films can be regulated by parameters of frequency of the applied field, voltage, electrode spacing and the like.

Further, selective excitation is enabled by the shape of the applied field and the frequency control including modulation, and it is possible to selectively enhance the film forming speed of a specific compound and to control the purity of impurities or the like.

### BRIEF DESCRIPTION OF THE DRAWINGS

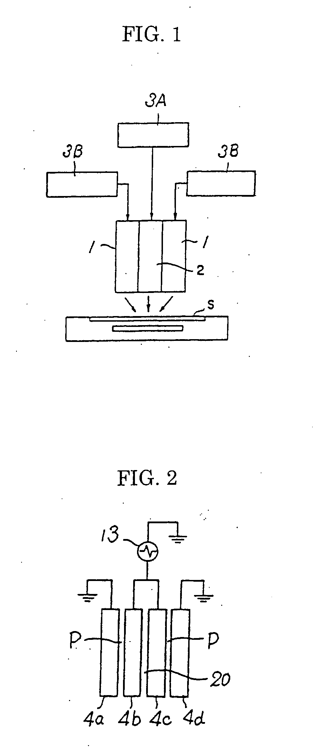

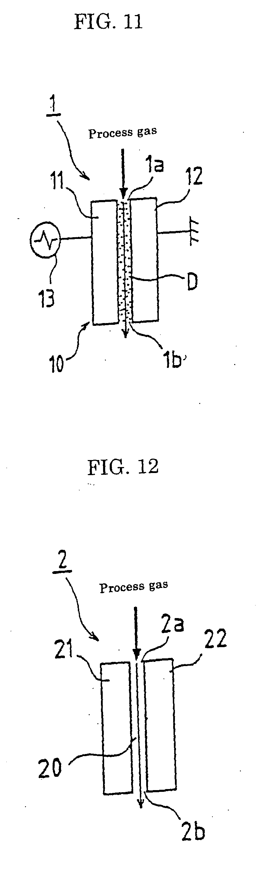

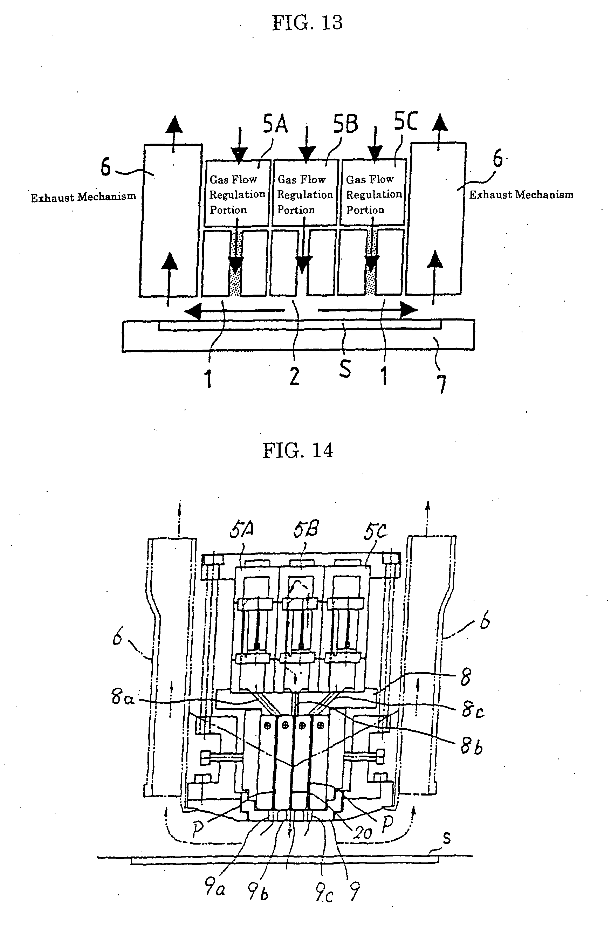

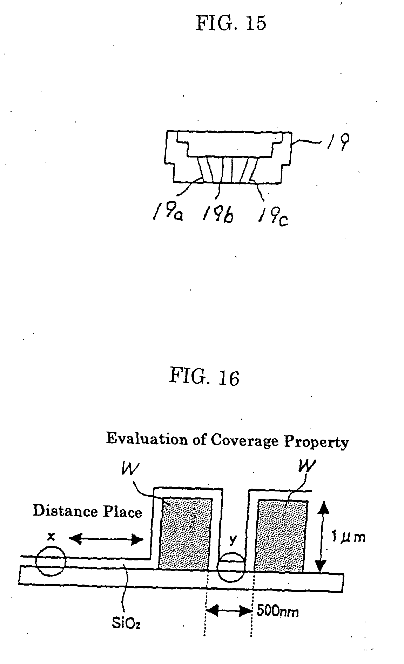

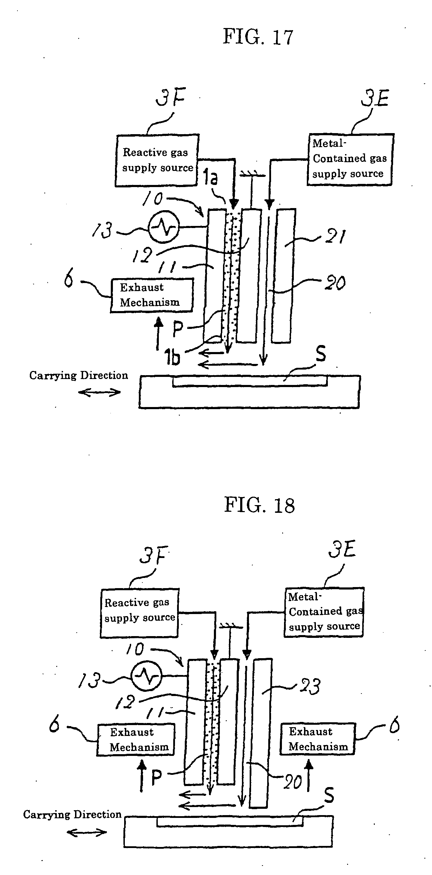

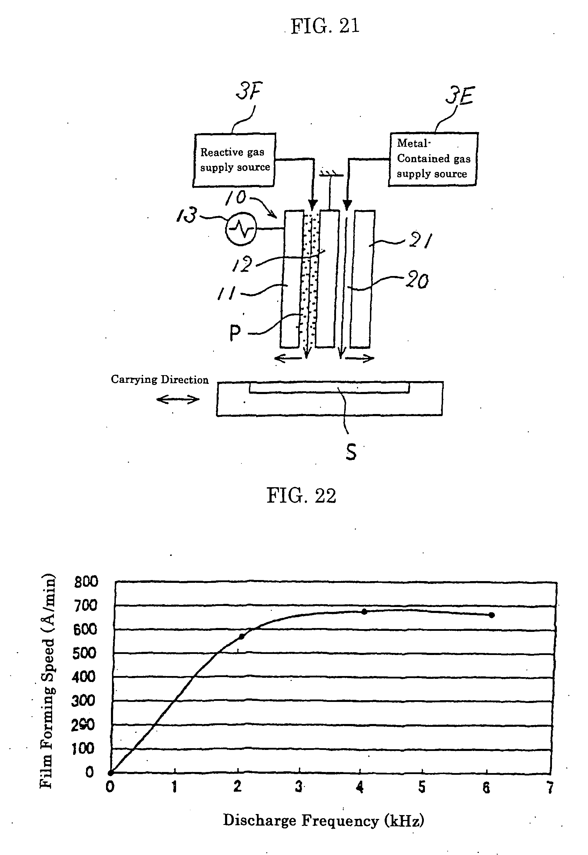

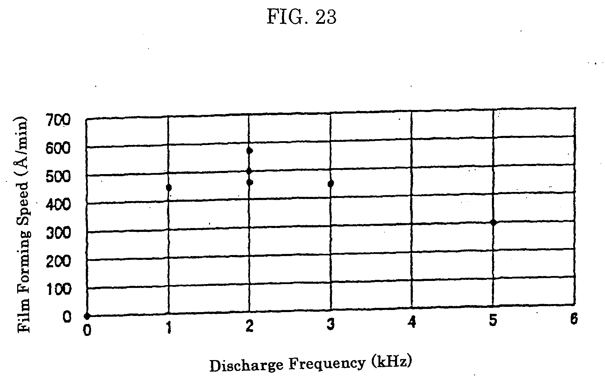

FIG. 1 is a view schematically showing the structure of one embodiment of the oxide film forming apparatus according to the present invention; FIGS. 2 to 10 are views schematically showing the structure of another embodiment of the oxide film forming apparatus according to the present invention; FIG. 11 is a view schematically showing the structure of a discharge processing section used in the form of carrying out the oxide film forming apparatus according to the present invention; FIG. 12 is a view schematically showing the structure of a gas introducing portion used in the form of carrying out the oxide film forming apparatus according to the present invention; FIG. 13 is a view schematically showing an emitting head of the oxide film forming apparatus according to the present invention; FIG. 14 is a longitudinal sectional view of an emitting head of the oxide film forming apparatus according to the present invention; FIG. 15 is a longitudinal sectional view of another embodiment of a lower slit; FIG. 16 is an explanatory view of a method of evaluating a coverage property; FIGS. 17 to 21 are views schematically showing the structure of still another embodiments of the oxide film forming apparatus according to the present invention; FIG. 22 is a view showing the film forming result of Embodiment 14 of the present invention and a graph showing a relationship between a film forming speed and a discharge frequency; and FIG. 23 is a view showing the film forming result of Comparative Example 5 of the present invention and a graph showing a relationship between a film forming speed and a discharge frequency.

### BEST MODE FOR CARRYING OUT THE INVENTION

The preferred embodiments of the oxide film forming apparatus according to the present invention will be described hereinafter with reference to the accompanying drawings.

### <Embodiment 1>

FIG. 1 is a view schematically showing the structure of one embodiment of the oxide film forming apparatus according to the present invention.

The oxide film forming apparatus shown in FIG. 1 is provided with two discharge processing sections 1, 1, a gas introducing portion 2, and a process gas supply source (TMOS) 3A for supplying two components of process gases, and two process gas supply sources (O₂) 3B, 3B or the like.

The discharge processing sections 1, 1 and the respective parts of the gas introducing portion 2 are arranged in the state adjacent to each other in one direction in order of the discharge processing section 1, the gas introducing portion 2, and the discharge processing section 1, and the process gases emitted from gas emitting ports 1b, 2b of the respective parts (see FIGS. 11 and 12) are mixed in the vicinity of the surface of a substrate S.

The discharge processing section 1 is provided with an opposite electrodes 10 comprising a voltage applied electrode 11 and a ground electrode 12, as shown in FIG. 11. The opposite electrodes 10 are in the form of a lengthy plate extending vertically with respect to paper surface, and the length thereof is made larger than the width of the substrate S to be carried across.

The voltage applied electrode 11 and the ground electrode 12 of the opposite electrodes 10 are oppositely arranged so as to be parallel with each other at a distance of a fixed spacing, and a discharge space D is formed between the voltage applied electrode 11 and the ground electrode 12.

The surfaces of the voltage applied electrode 11 and the ground electrode 12 are respectively covered by solid dielectrics (not shown).

A gas introducing port 1a is provided on one side of the discharge space D in the opposite electrodes 10, and a gas emitting port 1b is provided on the other side thereof, whereby a process gas can be supplied between the voltage applied electrode 11 and the ground electrode 12 through the gas introducing port 1a.

And, a voltage (a pulse voltage) is applied, from a power source 13, between the voltage applied electrode 11 and the ground electrode 12 in the gas supplying state, whereby a glow discharge plasma (a normal pressure plasma) is generated between the voltage applied electrode 11 and the ground electrode 12, and the process gas is subjected to discharge processing.

The discharge processed process gas emits toward the substrate S from the gas emitting port 1b. The gas emitting port 1b is formed to be a slit crossing the substrate S to be carried, and the length thereof is approximately the same as the length of the opposite electrodes 10.

In the discharge processing section 1 shown in FIG. 11, opposite electrodes comprising two electrodes are provided, but this arrangement is not limited thereto but there may be used a discharge processing section provided with opposite electrodes comprising three or more electrodes.

The gas introducing portion 2 is provided with a pair of opposite flat plates 21, 22 oppositely arranged so as to be parallel with each other at fixed intervals, as shown in FIG. 12, and a gas passing path 20 is formed between the pair of opposite flat plates 21, 22. An inlet side as one end side of the gas passing path 20 and an outlet side as the other end side thereof constitute a gas introducing port 2a and a gas emitting port 2b, respectively, and the process gas supplied from the gas introducing port 2a into the gas passing path 20 emits, after a gas flow has been put in order within the gas passing path 20, toward the substrate S from the gas emitting port 2b. It is noted that the discharge processing is not carried out in the gas introducing portion 2.

In the present embodiment, the discharge processing sections 1, 1 and the gas introducing portion 2 have the structure in which four flat plate type electrodes 4a, 4b, 4c and 4d are oppositely arranged in parallel, as shown in FIG. 2, and a pulse voltage is applied to the two electrodes 4b, 4c on the central side, whereas the two electrodes 4a, 4d on the outer side are grounded.

Two discharge processing sections 1, 1 are composed of a pair of opposite electrodes 4a, 4b and a pair of opposite electrodes 4c, 4d, and discharge spaces D are defined between the electrodes 4a, 4b and between the electrodes 4c, 4d.

The gas introducing portion 2 is composed of a pair of opposite electrodes 4b, 4c, and a gas passing path 20 is defined between the electrodes 4b, 4c. Since the pair of opposite electrodes 4b, 4c are connected in parallel with the power source 13, a non-discharge space is formed between the electrodes 4b, 4c.

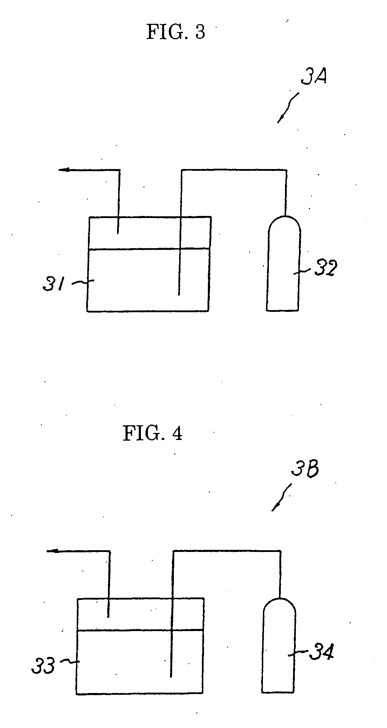

In the present embodiment, a process gas supply source (TMOS) 3A has the structure in which a carrier gas cylinder 32 is connected to a silicon-contained raw material storage tank 31 through a piping, as shown in FIG. 3, so that a carrier gas flown out of the carrier gas cylinder 32 is introduced into the silicon-contained raw material storage tank 31, and a silicon-contained gas vaporized together with the carrier gas is supplied.

As the silicon-contained raw material, TEOS or TMOS is used, and as the carrier gas, a nitrogen (N₂) gas which is one of inert gases is used.

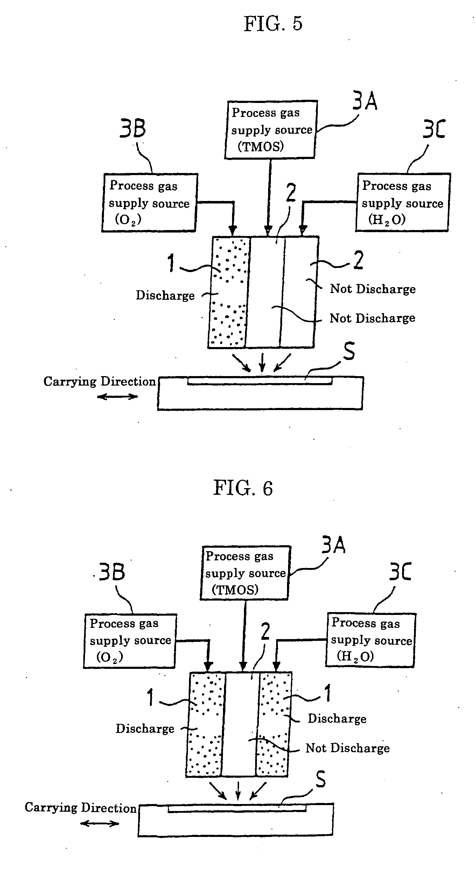

Further, a process gas supply source (O₂) 3B has the structure in which an oxygen cylinder 34 is connected to a super pure water storage tank 33 through a piping, as shown in FIG. 4, so that an oxygen (O₂) gas flown out of the oxygen cylinder 34 is introduced into the super pure water storage tank 33, and a super pure water (H₂O) vaporized together with the oxygen (O₂) gas is supplied.

It is noted that only the oxygen (O₂) gas may be supplied as the process gas (B) to an emitting head without using the super pure water.

And, in this embodiment, as shown in FIG. 1, each process gas supply sources (O₂) 3B, 3B are connected to gas introducing ports 1a of each of the discharge processing sections 1, 1, a process gas supply source (TMOS) 3A is connected to the gas introducing port 2a of the gas introducing portion 2, O₂ from the process gas supply sources 3B, 3B is subjected to discharge processing in the discharge processing sections 1, 1, and the discharge processed O₂ and TMOS (not discharge processed) supplied from the process gas supply source 3A and having passed through the gas introducing portion 2 are mixed in the vicinity of the surface of the substrate S to thereby form a silicon oxide film (SiO₂) on the surface of the substrate S.

As described above, according to this embodiment, since TMOS not discharge processed is mixed with the gas in which O₂ is discharge processed, a silicon oxide film which is excellent in both membranous and coverage property can be formed at a fast film forming speed.

### <Embodiment 2>

FIG. 5 is a view schematically showing the structure of another embodiment of the oxide film forming apparatus according to the present invention.

The oxide film forming apparatus shown in FIG. 5 is provided with a discharge processing section 1, two gas introducing portions 2, 2, a process gas supply source (TMOS) 3A for supplying three components of process gases, a process gas supply source (O₂) 3B, and a process gas supply source (H₂O) 3C.

The discharge processing sections 1 and the respective parts of the gas introducing portions 2, 2 are arranged in the state adjacent to each other in one direction in order of the discharge processing section 1, the gas introducing portion 2, and the gas introducing portion 2, and the discharge processing section 1, and the process gases emitted from gas emitting ports 1b, 2b of the respective parts (see FIGS. 11 and 12) are mixed in the vicinity of the surface of a substrate S.

In the discharge processing section 1 and the gas introducing portion 2, the construction shown in FIGS. 11 and 12 is used similarly to the above-described Embodiment 1.

And, in this embodiment, as shown in FIG. 5, the process gas supply source (O₂) 3B is connected to the gas introducing port 1a of the discharge processing section 1, the process gas supply source (TMOS) 3A and the process gas supply source (H₂O) 3C are respectively connected to the gas introducing ports 2a of the gas introducing portions 2, 2, O₂ from the process gas supply source 3B is subjected to the discharge processing in the discharge processing section 1, and the discharge processed O₂ and TMOS and H₂O (which are not discharge processed) supplied from the process gas supply sources 3A, 3C and having passed through the each gas introducing portion 2 are mixed in the vicinity of the surface of the substrate S to thereby form a silicon oxide film (SiO₂) on the surface of the substrate S.

As described above, according to this embodiment, since TMOS and H₂O not discharge processed are mixed with the gas in which O₂ is discharge processed, a silicon oxide film which is excellent in both membranous and coverage property can be formed at a fast film forming speed.

### <Embodiment 3>

FIG. 6 is a view schematically showing the structure of another embodiment of the oxide film forming apparatus according to the present invention.

The oxide film forming apparatus shown in FIG. 6 is provided with two discharge processing sections 1, 1, a gas introducing portions 2, a process gas supply source (TMOS) 3A for supplying three components of process gases, a process gas supply source (O₂) 3B, and a process gas supply source (H₂O) 3C.

The respective parts of the discharge processing sections 1, 1 and the gas introducing portion 2 are arranged in the state adjacent to each other in one direction in order of the discharge processing section 1, the gas introducing portion 2, and the discharge processing section 1, and the process gases emitted from gas emitting ports 1b, 2b of the respective parts (see FIGS. 11 and 12) are mixed in the vicinity of the surface of a substrate S.

In the discharge processing section 1 and the gas introducing portion 2, the construction shown in FIGS. 11 and 12 is used similarly to the above-described Embodiment 1.

And, in this embodiment, the process gas supply source (O₂) 3B and the process gas supply source (H₂O) 3C are connected to the gas introducing port 1a of the each discharge processing sections 1, 1, the process gas supply source (TMOS) 3A is connected to the gas introducing port 2a of the gas introducing portion 2, O₂ and H₂O from the process gas supply sources 3B, 3C are subjected to the discharge processing in the respective discharge processing sections 1, 1, and the discharge processed O₂ and H₂O and TMOS (not discharge processed) supplied from the process gas supply source 3A and having passed through the gas introducing portion 2 are mixed in the vicinity of the surface of the substrate S to thereby form a silicon oxide film (SiO₂) on the surface of the substrate S.

As described above, according to this embodiment, since O₂ and H₂O are individually discharge processed, and TMOS not discharge processed is mixed with the discharge processed gases, a silicon oxide film which is excellent in both membranous and coverage property can be formed at a fast film forming speed.

### <Embodiment 4>

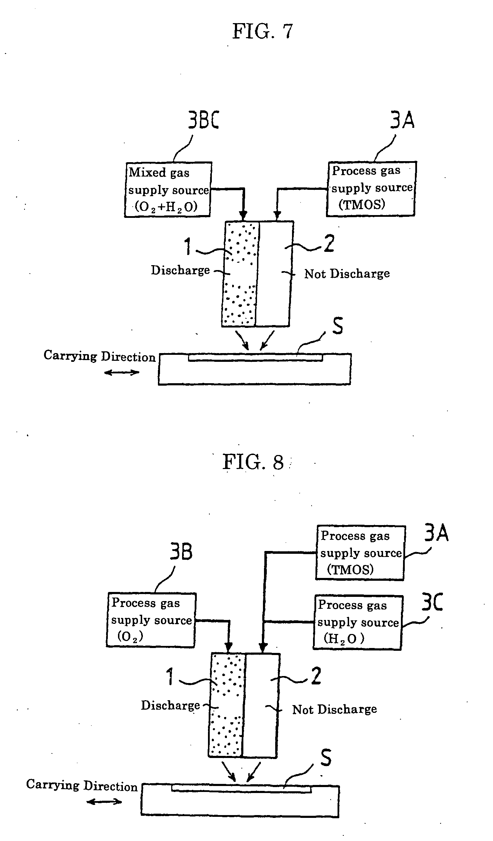

FIG. 7 is a view schematically showing the structure of another embodiment of the oxide film forming apparatus according to the present invention.

The oxide film forming apparatus shown in FIG. 7 is provided with a discharge processing section 1, a gas introducing portions 2, a process gas supply source 3A for supplying a process gas (TMOS), and a mixed gas supply source 3BC for supplying a mixed gas (O₂+ H₂O) in which two components of process gases are mixed.

The discharge processing section 1 and the gas introducing portion 2 are arranged in the state adjacent to each other in one direction, and the process gases emitted from gas emitting ports 1b, 2b of the respective parts (see FIGS. 11 and 12) are mixed in the vicinity of the surface of a substrate S.

In the discharge processing section 1 and the gas introducing portion 2, the construction shown in FIGS. 11 and 12 is used similarly to the above-described Embodiment 1.

And, in this embodiment, the mixed gas supply source 3BC is connected to the gas introducing port 1a of the discharge processing section 1, the process gas supply source 3A is connected to the gas introducing port 2a of the gas introducing portion 2, the mixed gas (O₂ + H₂O) from the mixed gas supply sources 3BC is subjected to the discharge processing in the discharge processing section 1, and the discharge processed mixed gas (O₂ + H₂O) and TMOS (not discharge processed) supplied from the process gas supply source 3A and having passed through the gas introducing portion 2 are mixed in the vicinity of the surface of the substrate S to thereby form a silicon oxide film (SiO₂) on the surface of the substrate S.

As described above, according to this embodiment, since the mixed gas of O₂ and H₂O is subjected to the discharge processing, and TMOS not discharge processed is mixed with the discharge processed mixed gas, a silicon oxide film which is excellent in both membranous and coverage property can be formed at a fast film forming speed. Further, since one gas introducing portion will suffice, the cost can be suppressed.

### <Embodiment 5>

FIG. 8 is a view schematically showing the structure of another embodiment of the oxide film forming apparatus according to the present invention.

The oxide film forming apparatus shown in FIG. 8 is provided with a discharge processing section 1, a gas introducing portions 2, a process gas supply source 3B for supplying a process gas (O₂), and a process gas supply source (TMOS) 3A, and a process gas supply source (H₂O) 3C. Since TMOS and H₂O are high in reactivity, TMOS and H₂O supplied from the process gas supply source 3A and the process gas supply source 3C, respectively, are mixed immediately before the gas introducing portion 2, and the mixed gas (TMOS + H₂O) is supplied to the gas introducing portion 2.

The discharge processing section 1 and the gas introducing portion 2 are arranged in the state adjacent to each other in one direction, and the process gases emitted from gas emitting ports 1b, 2b of the respective parts (see FIGS. 11 and 12) are mixed in the vicinity of the surface of a substrate S.

In the discharge processing section 1 and the gas introducing portion 2, the construction shown in FIGS. 11 and 12 is used similarly to the above-described Embodiment 1.

And, in this embodiment, the process gas supply source 3B is connected to the gas introducing port 1a of the discharge processing section 1, the process gas supply source 3A and the process gas supply source 3C are connected to the gas introducing port 2a of the gas introducing portion 2, O₂ from the process gas supply sources 3B is subjected to the discharge processing in the discharge processing section 1, and the discharge processed O₂ and the mixed gas (TMOS + H₂O : not discharge processed) supplied from the process gas supply source 3A and the process gas supply source 3C and having passed through the gas introducing portion 2 are mixed in the vicinity of the surface of the substrate S to thereby form a silicon oxide film (SiO₂) on the surface of the substrate S.

As described above, according to this embodiment, since the mixed gas (TMOS + H₂O) not subjected to the discharge processing is mixed with the discharge processed O₂, a silicon oxide film which is excellent in both membranous and coverage property can be formed at a fast film forming speed.

### <Embodiment 6>

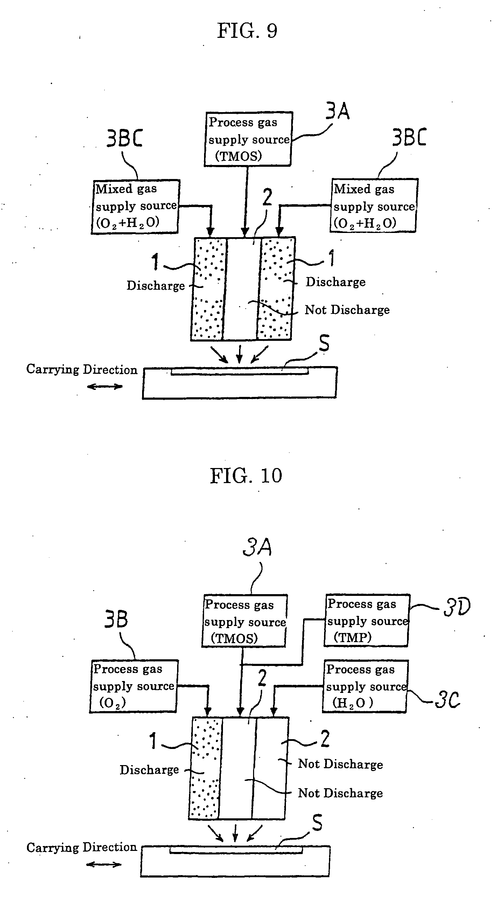

FIG. 9 is a view schematically showing the structure of another embodiment of the oxide film forming apparatus according to the present invention.

The oxide film forming apparatus shown in FIG. 9 is provided with two discharge processing sections 1, 1, a gas introducing portions 2, a process gas supply source 3A for supplying a process gas (TMOS), and two mixed gas supply sources 3BC, 3BC for supplying a mixed gas (O₂+ H₂O).

The respective parts of the discharge processing sections 1, 1 and the gas introducing portion 2 are arranged in the state adjacent to each other in one direction in order of the discharge processing section 1, the gas introducing portion 2, and the discharge processing section 1, and the process gases emitted from gas emitting ports 1b, 2b (see FIGS. 11 and 12) of the respective parts are mixed in the vicinity of the surface of a substrate S.

In the discharge processing section 1 and the gas introducing portion 2, the construction shown in FIGS. 11 and 12 is used similarly to the above-described Embodiment 1.

And, in this embodiment, the mixed gas supply sources 3BC, 3BC are connected to the gas introducing ports 1a of the discharge processing sections 1, 1, respectively, the process gas supply source (TMOS) 3A is connected to the gas introducing port 2a of the gas introducing portion 2, the mixed gas (O₂+ H₂O) from the mixed gas supply sources 3BC, 3BC is subjected to the discharge processing in the respective discharge processing sections 1, 1, and the discharge processed mixed gas (O₂+ H₂O) and the TMOS (not discharge processed) supplied from the process gas supply source 3A and having passed through the gas introducing portion 2 are mixed in the vicinity of the surface of the substrate S to thereby form a silicon oxide film (SiO₂) on the surface of the substrate S.

As described above, according to this embodiment, since the mixed gases (two systems) of O₂ and H₂O are respectively subjected to the discharge processing and TMOS not discharge processed is mixed with the discharge processed mixed gas, a silicon oxide film which is excellent in both membranous and coverage property can be formed at a fast film forming speed.

Here, in the above-described embodiments, the CVD processing is carried out while carrying the substrate S in the lateral direction (in the direction perpendicular to the gas passing path of the gas introducing portion).

Further, in the above-described embodiments, while TMOS is used as the process gas (raw gas), even if MTMOS is used in place of the former, the effect equal thereto can be obtained. Further, even if N₂O is used in place of O₂ which is a process gas (a reactive gas), the effect equal thereto can be obtained.

### <Embodiment 7>

FIG. 10 is a view schematically showing the structure of another embodiment of the oxide film forming apparatus according to the present invention.

The oxide film forming apparatus shown in FIG. 10 is provided with, in addition to the structure of the oxide film forming apparatus shown in FIG. 5, a process gas supply source 3D for supplying a process gas (TMP). TMOS supplied from the process gas supply source 3A and TMP supplied from the process gas supply source 3D are mixed before the gas introducing portion 2, and the resultant mixed gas (TMOS + TMP) is supplied to the gas introducing portion 2.

In this embodiment, since TMP is mixed with TMOS, a silicon oxide film in which P is doped can be formed. The P doped silicon oxide film is excellent in both membranous and coverage property, similar to a non-doped silicon oxide film.

In this embodiment, there is provided, in addition to the structure of the oxide film forming apparatus shown in FIG. 5, the process gas supply source 3D for supplying TMP, but the structure of the oxide film forming apparatuses shown in FIGS. 6 to 9 may be provided with the process gas supply source 3D for supplying TMP.

Further, as the process gas (D), TEP, TMB, and TEB may be used in addition to TMP.

### <Embodiment 8>

FIG. 17 is a view schematically showing the structure of the oxide film forming apparatus according to the present invention.

The oxide film forming apparatus shown in FIG. 17 is provided with an opposite electrode 10 comprising a voltage applied electrode 11 and a ground electrode 12, an opposite flat plate 21, a power source 13, a reactive gas supply source 3F, a metal-contained gas supply source 3E, and an exhaust mechanism 6.

The voltage applied electrode 11 and the ground electrode 12 of the opposite electrode 10 are oppositely arranged so as to be parallel with each other at fixed intervals, and a plasma space P is formed between a pair of the electrodes 11 and 12. The surfaces of the voltage applied electrode 11 and the ground electrode 12 are respectively covered with solid dielectrics (not shown).

The opposite electrode 10 is provided with a gas introducing port 1a and a gas emitting port 1b. A reactive gas supply source 3F is connected to the gas introducing port 1a, and a reactive gas can be supplied between the voltage applied electrode 11 and the ground electrode 12. The voltage applied electrode 11 and the ground electrode 12 constituting the opposite electrode 10 are rectangular flat plate electrodes, and the shape of the gas emitting port 1b is a rectangle elongating in the depth direction of paper surface.

The opposite flat plate 21 is provided on the side of the ground electrode 12 of the opposite electrode 10. The opposite flat plate 21 is arranged in the state opposed at a fixed spacing with respect to the ground electrode 12, a gas passing path 20 is formed between the opposite flat plate 21 and the ground electrode 12. A metal-contained gas from a metal-contained gas supply source 3E is supplied to the gas passing path 20, and the supplied metal-contained gas is joined with a reactive gas after passage of the plasma space P emitted from the gas emitting port 1b.

The opposite flat plate 21 is a flat plate having the same shape (rectangle) and dimension as the voltage applied electrode 11 and the ground electrode 12 of the opposite electrode 10, and the outlet shape of the gas passing path 20 is a rectangle elongating in the depth direction of paper surface similar to the gas emitting port 1b of the opposite electrode 10. The parallel flat plate 21 may be made of either metal or insulating material.

The exhaust mechanism 6 is arranged on the side of the voltage applied electrode 11 of the opposite electrode 10, and the gas between the opposite electrode 10 and opposite flat plate 21 and the substrate S is exhausted forcibly in the same direction (leftward in the FIG.1). In the exhaust mechanism 6, for example, a blower or the like is used.

And, in the oxide film forming apparatus having the construction as described above, the substrate S is placed at a position opposite to the gas emitting port 1b of the opposite electrode 10 and the outlet of the gas passing path 20, then there is exhausted forcibly in one direction between the opposite electrode 10 and opposite flat plate 21 and the substrate S by the exhaust mechanism 6, further a metal-contained gas (for example, TMOS, TEOS or the like) from the metal-contained gas supply source 3E is supplied to the gas passing path 20, and a reactive gas (for example, O₂ or the like) from a reactive gas supply source 3F is supplied between the voltage applied electrode 11 and the ground electrode 12. In that state, an electric filed (a pulse field) from a power source 13 is applied between the voltage applied electrode 11 and the ground electrode 12 to generate a plasma space P between the voltage applied electrode 11 and the ground electrode 12 and to plasma excite the reactive gas. The reactive gas (in the excited state) having passed through the plasma space P and the metal-contained gas having passed through the gas passing path 20 emit toward the substrate S. Here, in this embodiment, since there is carried out the forcing exhaust in one direction by the exhaust mechanism 6, a joined gas of the reactive gas having passed through the plasma space P and the metal-contained gas emitted out of the gas passing path 20 will be a gas flow approximately parallel with the surface to be processed of the substrate S in the uniformly mixed state, and flows in one direction toward the place where the exhaust mechanism 6 is arranged (left side in FIG. 17).

As described above, according to this embodiment, the metal-contained gas is joined with the reactive gas which is formed into an active species by passing through the plasma space P , and the active species comes in contact with the metal-contained gas whereby they are reacted to form a film. Therefore, the metal-contained gas is used effectively for the film forming reaction, thus making it possible to prevent the adhesives to the electrode or impurities from occurring. Accordingly, the film forming speed of a metal-contained thin film can be enhanced to a speed capable of being utilized industrially, and in addition, the maintenance spacing can be made longer.

In the oxide film forming apparatus shown in FIG. 17, the discharge space P and the gas passing path 20 of the metal-contained gas are arranged in parallel and vertically to the surface to be processed of the substrate S, but the arrangement is not limited to that construction, for example, the discharge space P and the gas passing path 20 of the metal-contained gas may be designed to be joined at an angle, or the construction may be employed in which the joined gas is emitted obliquely with respect to the surface to be processed of the substrate S.

### <Embodiment 9>

FIG. 18 is a view schematically showing the structure of still another embodiments of the oxide film forming apparatus according to the present invention.

In this embodiment, in addition to the structure of FIG. 17, there is featurized in that an exhaust mechanism 6 is arranged also on the side of the opposite flat plate 23, and the lower portion of the opposite flat plate 23 is extended to the place near the substrate S, and the exhaust conductance by the exhaust mechanism 6 on the side of the opposite flat plate 23 is made to be smaller (for example, about 1/4) than the exhaust conductance by the exhaust mechanism 6 on the side of the voltage applied electrode 11 of the opposite electrode 10. Other structures are similar to the embodiment of FIG. 17.

According to the embodiment of FIG. 18, since the exhaust conductance on the side of the voltage applied electrode 11 of the opposite electrode 10 and the exhaust conductance on the side of the opposite flat plate 23 are controlled, the approximately whole quantity of the metal-contained gas introduced into the gas passing path 20 can be flown in one direction (leftward in FIG.18). That is, the total flow rate of the introducing flow rate of the metal-contained gas and reactive gas can be made to be approximately the same as the flow rate of the gas flow flowing approximately in parallel with the substrate S. Moreover, since the winding of gas from outside disappears, this is particularly suitable for the film forming processing in case of being adverse to a mixing of impurities.

### <Embodiment 10>

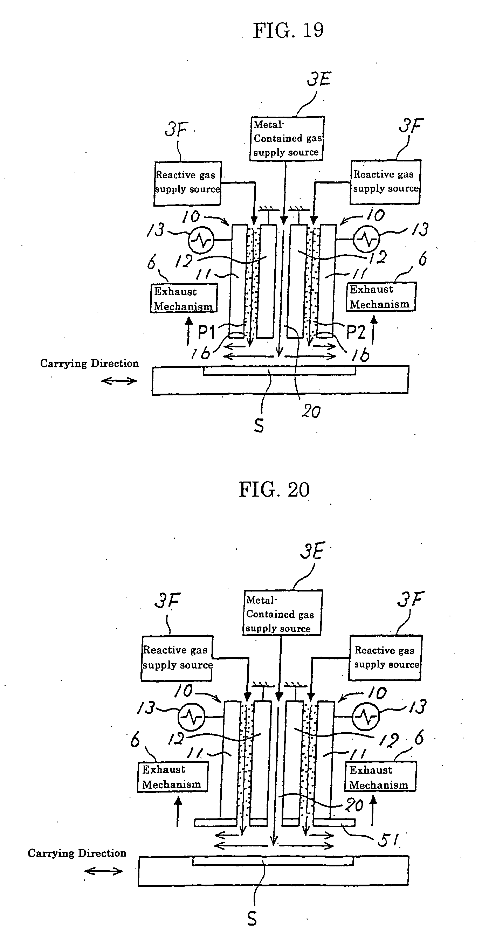

FIG. 19 is a view schematically showing the structure of still another embodiments of the oxide film forming apparatus according to the present invention.

The oxide film forming apparatus shown in FIG. 19 is provided with two sets of opposite electrodes 10, 10 comprising voltage applied electrodes 11, 11 and ground electrodes 12,12, power sources 13, 13, reactive gas supply sources 3F, 3F, a metal-contained gas supply source 3E, and exhaust mechanisms 6, 6.

The voltage applied electrodes 11, 11 of the opposite electrodes 10, 10 and the ground electrodes 12, 12 are arranged oppositely so as to be parallel with each other at a fixed spacing. The surfaces of the voltage applied electrodes 11, 11 and the ground electrodes 12, 12 are covered by the solid dielectrics (not shown), respectively.

The reactive gas from the reactive gas supply source 3F is supplied between the voltage applied electrode 11 of the opposite electrode 10 and the ground electrode 12 (a plasma space P1). Further, the reactive gas from the reactive gas supply source 3F is supplied between the voltage applied electrode 11 of the opposite electrode 10 and the ground electrode 12 (a plasma space P2).

The opposite electrode 10 and the opposite electrode 10 have the construction such that the arrangements of the voltage applied electrodes 11, 11 and the ground electrodes 12, 12 are symmetrical to left and right (the ground electrodes 12, 12 are provided internally). Further, the ground electrode 12 of the opposite electrode 10 and the ground electrode 12 of the opposite electrode 10 are arranged in the opposite state at a fixed spacing. A gas passing path 20 is formed between these two ground electrodes 12, 12. The metal-contained gas from the metal-contained gas supply source 3E is supplied to the gas passing path 20.

The exhaust mechanisms 6, 6 are arranged, on both sides with two sets of opposite electrodes 10, 10 put therebetween, at a position so that they are linear symmetrical with respect to the center axis of the gas passing path 20, and the exhaust conductance on the side of the opposite electrode 10 (left side in FIG. 19) and the exhaust conductance on the side of the opposite electrode 10 (right side in FIG. 19) are to be the same. In the exhaust mechanisms 6, 6, for example, a blower or the like is used.

And, in the oxide film forming apparatus having the above-described construction, the substrate S is placed at a position opposite to the extreme end (an emitting port) of the two sets of opposite electrodes 10, 10, the forcing exhaust by the two exhaust mechanisms 6, 6 is carried out, further the metal-contained gas (for example, TMOS, TEOS or the like) from the metal-contained gas supply source 3E is supplied to the gas passing path 20, and the reactive gases (for example, O₂ or the like) from the reactive gas supply sources 3F, 3F are supplied between the voltage applied electrode 11 of the opposite electrode 10 and the ground electrode 12 and between the voltage applied electrode 11 of the opposite electrode 10 and the ground electrode 12, respectively.

In this state, an electric field (a pulse field) from the power sources 13, 13 is applied respectively to the opposite electrodes 10, 10 to generate plasma spaces P1, P2 between the voltage applied electrode 11 and the ground electrode 12 and between the voltage applied electrode 11 and the ground electrode 12, and to plasma excite the respective reactive gases. The reactive gases (in the excited state) having passed through the plasma spaces P1, P2 and the metal-contained gas having passed through the gas passing path 20 emit from the emitting ports toward the substrate S. Here, in this embodiment, since the apparatus structure and the exhaust conductance are made to be symmetrical to left and right, a flow of a branch gas (a branch gas of the metal-contained gas) emitted out of the gas passing path 20 is mixed with the gas flows of the reactive gases having passed through the plasma spaces P1 and P2 and emitted from the gas emitting ports 11b, 1b to form a gas flow approximately in parallel with the surface to be processed of the substrate S. Moreover, a mixed flow (a gas flow leftward in FIG. 19) of the reactive gas having passed through the plasma space P1 and the gas metal-contained gas is equivalent to a mixed flow (a gas flow rightward in FIG. 19) of the reactive gas having passed through the plasma space P2 and the metal-contained gas, and therefore a high film forming speed can be obtained in a stabilized manner.

In the construction shown in FIG. 19, forcing exhaust is carried out by the two exhaust mechanisms 6, 6, but if the gas flow rates of the reactive gases to be introduced into the opposite electrodes 10, 10 are the same, the equivalent state of a mixed flow (a gas flow leftward in FIG. 19) of the reactive gas having passed through the plasma space P1 and the gas metal-contained gas and a mixed flow (a gas flow rightward in FIG. 19) of the reactive gas having passed through the plasma space P2 and the gas metal-contained gas can be realized irrespective of the presence or absence of the forcing exhaust and the gas flow rate of the metal-contained gas introduced into the gas passing path 20.

### <Embodiment 11>

FIG. 20 is a view schematically showing the structure of still another embodiments of the oxide film forming apparatus according to the present invention.

In this embodiment, in addition to the structure of FIG. 19, there is featurized in that a gas flow regulating plate 51 is provided on the lower end (gas emitting side) of the opposite electrodes 10, 10.

If the gas flow regulating plate 51 is provided as described above, the mixing evenness and directivity of the joined gas of the reactive gas and the metal-contained gas are enhanced, and the disturbance of the gas flow is further reduced, and therefore, the membranous of the metal-contained thin film and the film forming speed can be further improved. Preferably, where such a gas flow regulating plate is provided, a ceramic porous plate is used as the gas flow regulating plate 51, and an N₂ gas is emitted from the surface of the porous plate to prevent the adhesion of a film on the gas flow regulating plate 51.

### [Embodiments]

The embodiments of the oxide film forming method and apparatus according to the present invention will be described hereinafter together with the comparative examples.

### <Embodiments 1 to 3>

### [Structure of apparatus]

First, the oxide film forming apparatus shown in Embodiments 1 to 3 is a concrete example of the construction shown in FIG.1, and in the emitting head, as shown in FIG.13, the discharge processing section 1, the gas introducing portion 2, and the discharge processing section 1 are arranged in the state of being adjacent each other in one direction in said order. Gas flow regulating portions 5A and 5C are connected, upstream in the gas flowing direction, to two discharge processing sections 1, 1. Further, the gas flow regulating portion 5B is connected to the central gas introducing portion 2. The exhaust mechanisms 6, 6 are arranged on the sides (leftward and rightward in the figure) of the discharge processing sections 1, 1, respectively.

Since the substrate place portion 7 moves in one direction or in both directions, the substrate S placed on the substrate place portion 7 is carried in one way or in round trip. The lower ends of the discharge processing sections 1, 1 are arranged so as to come close to the substrate S, and the distance between the discharge processing sections 1, 1 and the substrate surface is set to 0.5 to 30 mm. When not more than 0.5 mm, it possibly comes in contact with the discharge processing sections 1, 1 when the substrate is carried, and when exceeding 30 mm, the normal pressure plasma scatters to considerably lower the film forming efficiency. Particularly, preferably, it is set to 2 to 10 mm.

The above-described emitting head will be described more concretely. As shown in FIG. 14, it is composed of an upper slit 8 comprising gas flow regulating portions 5A, 5B, 5C for making a pressure distribution of gas to be supplied uniform, and an insulator such as ceramics, and a lower slit 9 comprising a discharge processing section 1, a gas introducing portion 2, and an insulator such as ceramics, and exhaust nozzles 6a, 6a of the exhaust mechanisms 6, 6 are provide around the emitting head.

As shown in FIG. 14, the silicon-contained gas supplied to the emitting head flows through the gas flow regulating portion 5B, a flow path 8b of the upper slit 8, and is introduced into a gas passing path 20 of the gas introducing portion 2. Then, it passes through an outflow path 9b of the lower slit 9, and emits from the emitting port 2b toward the substrate S.

As shown in FIG. 14, the oxygen (O₂) gas supplied to the emitting head flows through the gas flow regulating portions 5A, 5C, and the flow paths 8a, 8c of the upper slit 8, and is introduced into discharge spaces D, D of the discharge processing sections 1,1. And, in the discharge spaces D, D, a high frequency pulse voltage is applied to thereby generate a normal pressure plasma caused by a glow discharge, and the oxygen (O₂) gas in the excited state passes through outflow paths 9a, 9c of the lower slit 9, and emits from the emitting ports 1b, 1b toward the substrate S.

It is noted that the substrate S is placed on the substrate place portion 7, and is carried so as to cross the emitting ports 1b, 2b, 1b (in a separate way of speaking, four electrodes 4a, 4b, 4c, 4d).

The silicon-contained gas emitted from the emitting port 2b and the oxygen (O₂) gas in the excited state emitted from the emitting ports 1b, 1b are mixed and reacted in the vicinity of the surface of the substrate S to thereby form a silicon oxide film (SiO₂) on the surface of the substrate S.

Here, where the thickness of the silicon oxide film is insufficient, the substrate S may be carried in round trip. Further, where the width of the substrate S is larger than the width of the emitting head, the emitting head may scan the substrate S.

On the other hand, the mixed gas after the film forming processing is taken into the exhaust nozzles 6a, 6a of the exhaust mechanisms 6, 6, and are suitably discharged.

Here, the outflow paths 9a, 9b, 9c of the lower slit 9 are formed to be approximately in parallel, but as in the lower slit 19 shown in FIG. 15, the outflow paths 19a, 19c on both sides may be formed to be inclined inwardly with respect to the central outflow path 19b. In doing so, the silicon-contained gas and the oxygen (O₂) gas are more efficiently mixed and reacted in the vicinity of the surface of the substrate S, and therefore, the film forming speed of the silicon oxide film (SiO₂) can be made higher.

Further, in the lower slit, the form of an opening of the outflow path is not limited to slit-like, but a plurality of openings such as round hole, square hole or the like may be formed on a straight line.

A silicon oxide film was formed, using the oxide film forming apparatus as described above, by the process gas under the processing conditions described below. The gas flow rates are as shown in Table 1.

### [Processing conditions]

| | |
|---|---|
| Pressure of an atmosphere | 95 kPa |
| Heating temperature of a substrate | 350° C |
| Carrying speed of a substrate | 80 mm/min |
| Applied voltage Vpp | 14.0 kV |
| Pulse frequency | 20 kHz |

### [Process gas]

| | |
|---|---|
| Gas flow regulating portion 5A | O₂ + O₃ |
| Gas flow regulating portion 5B | TEOS +N₂ |
| Gas flow regulating portion 5C | O₂ + O₃ |

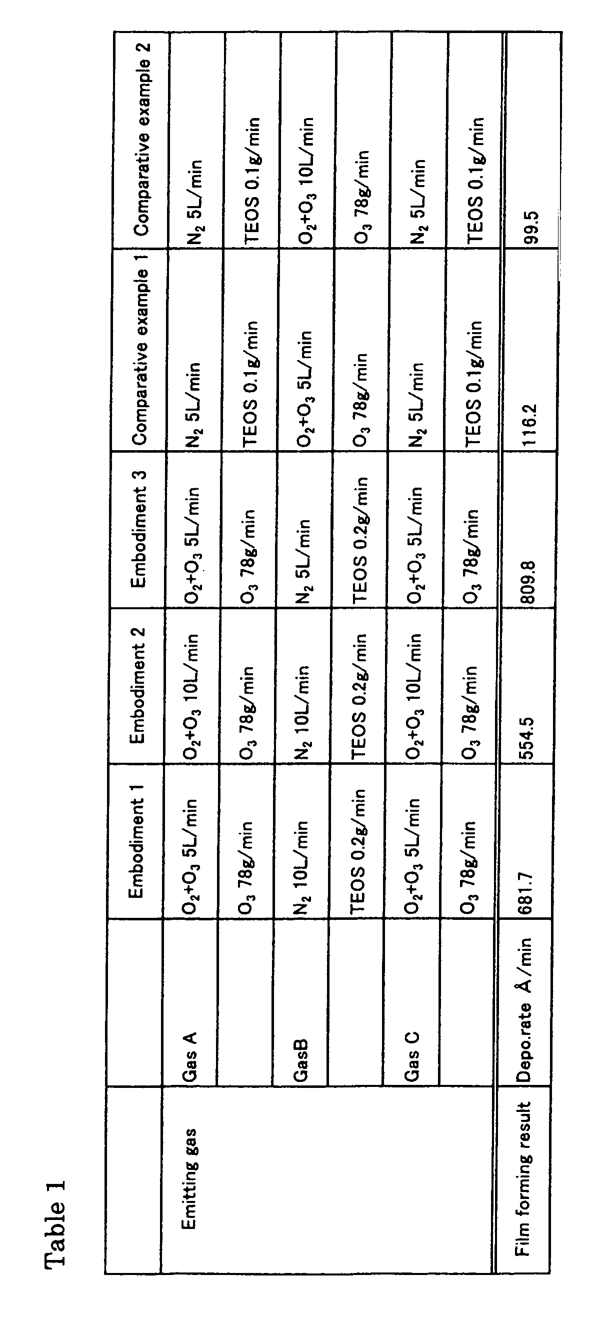

### <Comparative Examples 1, 2>

A silicon oxide film was formed, using the oxide film forming apparatus similar to Embodiment 1, under the processing conditions similar to Embodiments 1 to 3 except that supplying parts of a process gas were changed. The gas flow rates are as shown in Table 1.

### [Process gas]

| | |
|---|---|
| Gas flow regulating portion 12a | TEOS +N₂ |
| Gas flow regulating portion 12b | O₂ + O₃ |
| Gas flow regulating portion 12c | TEOS + N₂ |

In Embodiments 1 to 3 and Comparative Examples 1, 2, the film forming speed when the silicon oxide film was formed is as shown in Table 1.

It can be understood that referring to Table 1, according to the oxide film forming method of the present invention, the film forming speed is made high markedly.

### <Embodiment 4>

### [Structure of Apparatus]

The oxide film forming apparatus used in this Embodiment 4 is a concrete example of the construction shown in FIG. 9, and as shown in FIG. 13, the discharge processing section 1, the gas introducing portion 2 and the discharge processing section 1 are arranged in the state adjacent to each other in one direction in that order. Other structures are as described in Embodiment 1.

### [Processing conditions]

Substrate: Si wafer (8 inch, aluminum wiring formed article), being carried in the state set to the substrate place portion 7
Substrate temperature: 350° C
Gas flow conditions
Processing atmosphere: atmospheric pressure
Gas flow regulating portion 5A: O₂ = 10 SLM, H₂O = 0.5 g/min,
N₂ as a carrier gas of H₂O = 2 SLM
Gas flow regulating portion 5B: TMOS = 0.2 g/min, N₂ as a carrier gas of TMOS = 2 SLM
Gas flow regulating portion 5C: O₂ = 10 SLM, H₂O = 0.5 g/min, N₂ as a carrier gas of H₂O = 2 SLM
Discharge conditions: a pulse frequency = 10 kHz, applied voltage Vpp = 20 kV
Distance between a substrate and a discharge processing section = 4 mm
Carrying speed of substrate: 200 mm/min

A film was formed on the surface of the substrate S under the apparatus structure and conditions described above, and an Si O₂ film could be obtained at a film forming speed of 1800 Å/min. Further, the coverage property and the membranous after film forming processing were evaluated by the following method. The evaluated results (including the film forming speed) and the processing conditions are shown in Table 2 below.

It is found in this Embodiment 4, the coverage property is excellent (coverage = 1), and the membranous is also good (pressure resistance = 4.8 MV/cm).

### [Evaluation of Coverage Property]

As shown in FIG. 16, the film thickness (film thickness of SiO₂) at a point x distanced from an aluminum wiring W, and the film thickness at a y point between two aluminum wirings W, W are respectively measured, and the ratio between them ([film thickness at a y point]/[film thickness at a x point]) is obtained, then the evaluation is carried out.

### [Evaluation of Membranous]

The field strength to be the pressure resistance (1 x 10⁻⁷ A/cm²) is measured, and the evaluation is carried out from the result of measurement. Field strength = 3MV/cm or more is evaluated to be good.

### <Comparative Example 3>

As shown in Table 2 below, an SiO₂ film was formed on the surface of the substrate S under the same conditions as Embodiment 4 except that H₂O is not added, then the film forming speed was 1900 Å/min, which was approximately equal to the former. Further, the coverage property and the membranous after film forming processing were evaluated by the same method as Embodiment 4. The evaluated results (including the film forming speed) is shown in Table 2 below.

In this Comparative Example 3, the coverage property (coverage = 1) was good, and the film forming speed was approximately equal to that of Embodiment 4 (H₂O is added), but the pressure resistance is low (2.1 MV/cm).

However, an SiO₂ film was formed on the surface of the substrate S under approximately the same processing conditions as Embodiment 4 by the normal pressure heat CVD method of the TEOS/O₃ system, then the film forming speed was 1000Å/min, and the pressure resistance was 1.7 MV/cm.

Thereby, it was found that in any of Embodiment 4 or Comparative Example 3, both the membranous and the film forming speed enhanced markedly as compared with the normal pressure heat CVD method of the TEOS/O₃ system.

### <Embodiment 5>

As shown in Table 2 below, a film was formed on the surface of the substrate S under the same conditions as Embodiment 4 except that the adding quantity of H₂O was reduced to 0.05 g/min with respect to Embodiment 4, and an SiO₂ film could be obtained at a film forming speed of 1500 Å/min. Further, the coverage property and the membranous after film forming processing were evaluated by the same method as Embodiment 4. The evaluated results (including the film forming speed) are shown in Table 2 below.

It is understood from the results of Embodiment 5 that even if the adding quantity of H₂O was reduced to 0.05 g/min, the effects are obtained in both the film forming speed (1500 Å/min) and pressure resistance (4MV/cm).

### <Embodiment 6>

As shown in the following Table 2, a film was formed on the surface of the substrate S under the same conditions as Embodiment 1 except that the quantity of TMOS is reduced to 0.1 g/min and the adding quantity of H₂O is increased to 1.5 g/min with respect to Embodiment 4, and an SiO₂ film could be obtained at a film forming speed of 1400 Å/min. Further, the coverage property and the membranous after film forming processing were evaluated by the same method as Embodiment 1. The evaluated results (including the film forming speed) are shown in Table 2 below.

It is understood from the results of Embodiment 6 that when the adding quantity of H₂O with respect to TMOS is increased, even if TMOS as the reduced quantity is reduced to 1/2, the good film forming speed (1400 Å/min) is obtained. It is further understood that the pressure resistance is also good (5.5 MV/cm). Note, film forming processing was conducted with the adding quantity of H₂O increased more than that of Embodiment 6. then the enhancement of the performance was little.

### <Embodiment 7>

As shown in the following Table 2, a film was formed on the surface of the substrate S under the same conditions as Embodiment 4 except that the quantity of TMOS is increased to 1.5 g/min, with respect to Embodiment 4, the adding quantity of H₂O is also increased to 1.0 g/min, and the carrying speed of the substrate is doubled to 400 mm/min, then an SiO₂ film could be obtained at a very high film forming speed, 4800 Å/min. Further, the coverage property and the membranous after film forming processing were evaluated by the same method as Embodiment 4. The evaluated results (including the film forming speed) are shown in Table 2 below.

It is understood from the results of Embodiment 7 that both the quantity of TMOS as a raw material and the adding quantity of H₂O are increased, whereby the film forming processing at high speed becomes enabled. Note, the pressure resistance is lowered with respect to Embodiment 4, but a good value (3.5 MV/cm) can be secured as compared with the case where H₂O is not added (Comparative Example 3).

### <Embodiment 8>

As shown in the following Table 2, a film was formed on the surface of the substrate S under the same conditions as Embodiment 4 except that the raw material is changed to MTMOS, then an SiO₂ film could be obtained at a film forming speed of 1700 Å/min. Further, the coverage property and the membranous after film forming processing were evaluated by the same method as Embodiment 4. The evaluated results (including the film forming speed) are shown in Table 2 below.

It is understood from the results of Embodiment 8 that even if MTMOS is used in place of TMOS, substantially the same performance (film forming speed, membranous and coverage) can be secured.

### <Embodiment 9>

As shown in the following Table 2, a film was formed on the surface of the substrate S under the same conditions as Embodiment 4 except that O₂ is changed to N₂O, then an SiO₂ film could be obtained at a film forming speed of 1600 Å/min. Further, the coverage property and the membranous after film forming processing were evaluated by the same method as Embodiment 4. The evaluated results (including the film forming speed) are shown in Table 2 below.

It is understood from the results of Embodiment 9 that even if N₂O is used in place of O₂, substantially the same performance (film forming speed, membranous and coverage) can be secured.

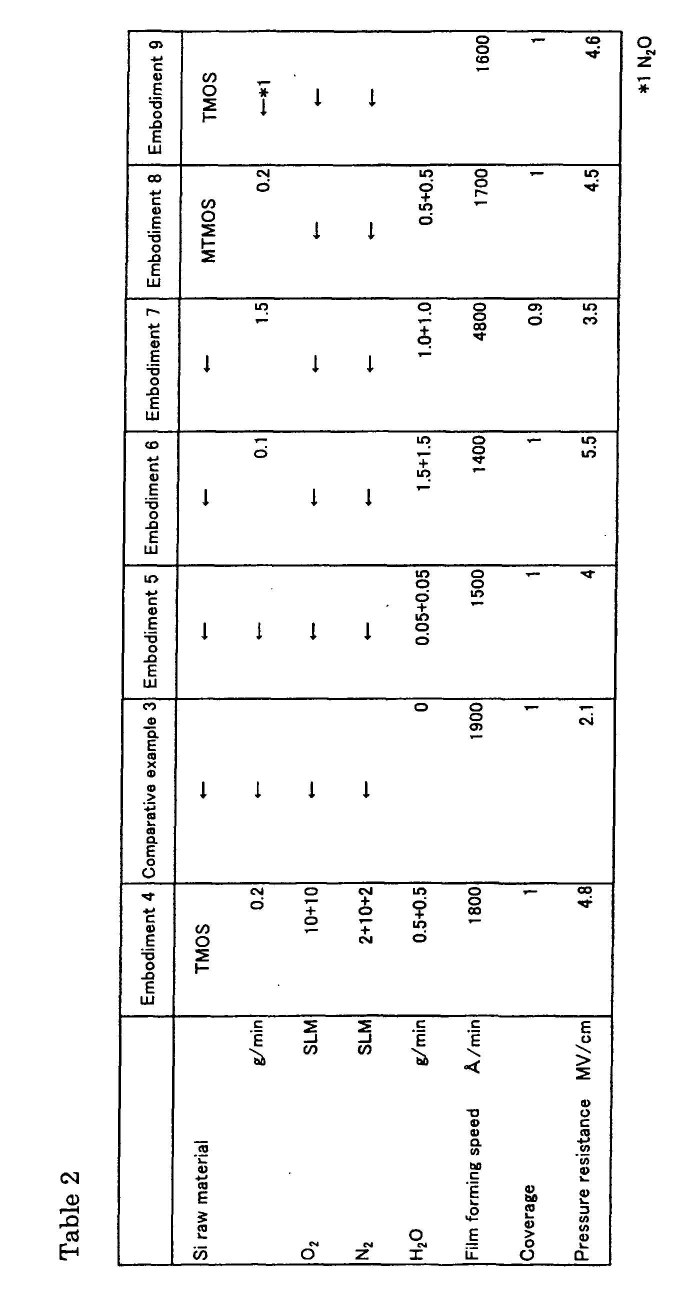

### <Comparative Example 4>

As shown in the following Table 3, a SiO₂ film was formed on the surface of the substrate S under the same conditions as Embodiment 4 except that the O₂ quantities of the gas flow regulating portion 5A and the gas flow regulating portion 5C are respectively reduced to 2SLM, and that the N₂ quantities (carrier gas quantities) of the gas flow regulating portion 5A and the gas flow regulating portion 5C are respectively increased to 10SLM with respect to Embodiment 4, then the film forming speed was lowered to 900 Å/min. Further, the coverage property and the membranous after film forming processing were evaluated by the same method as Embodiment 4. The evaluated results (including the film forming speed) are shown in Table 3 below.

In this Comparative Example 4, the coverage property (coverage =1) is good, but the film forming speed is slow as compared with Embodiment 4 and the pressure resistance is also low (2.4 MV/cm).

### <Embodiment 10>

A film was formed on the surface of the substrate S under the same conditions as Embodiment 4 except that the gas flow regulation of the gas flow regulating portions 5A to 5C of FIG. 13 is done under the conditions mentioned below, then a SiO₂ film could be obtained at film forming speed of 1800 Å/min. Further, the coverage property and the membranous after film forming processing were evaluated by the same method as Embodiment 4. The evaluated results (including the film forming speed) are shown in Table 3 below.

The gas flow regulating portions 5A and 5C: O₂ = 10 SLM

The gas flow regulating portions 5B: TMOS = 0.2 g/min, N₂ as a carrier gas of TMOS = 10 SLM, H₂O = 1.0 g/min.

It is understood from the results of Embodiment 10 that even if the discharge processing is not carried out for H₂O, if H₂O is added to TMOS to increase O₂, the performance (film forming speed, membranous, coverage) substantially equal to that of Embodiment 4 can be secured.

**Table 3**

| | | Comparative example 4 | Embodiment 10 |
|---|---|---|---|
| Si raw material | | TMOS | ← |
| | g/min | 0.2 | ← |
| O₂ | SLM | 2+2 | 10+10 |
| N₂ | SLM | 10+10+10 | 10 |
| H₂O | g/min | 0.5+0.5 | 1.0 |
| Film forming speed | Å/min | 900 | 1800 |
| Coverage | | 1 | 1 |
| Pressure resistance | MV/cm | 2.4 | 4.6 |

### <Embodiment 11>

A film was formed on the surface of the substrate S formed with an aluminum wiring pattern having an opening of width: 150nm and depth: 400nm under the same conditions as Embodiment 4 except that the substrate temperature, and distance between the substrate and the discharge processing section are determined under the conditions described below, then a SiO₂ film could be obtained at film forming speed of 1500 Å/min. Further, the above-described opening could be buried approximately completely.
Substrate temperature: 300 °C
Distance between the substrate and the discharge processing section = 3 mm

It is understood from the results of Embodiment 11 that according to the oxide film forming method of the present invention, an oxide film having a sufficient film thickness can be formed even in a very narrow opening.

### <Embodiment 12>

In the oxide film forming apparatus of FIG. 17, a voltage applied electrode 11 (made of SUS304, width 250 mm x length 50 mm x thickness 20 mm, solid dielectric : alumina) and a ground electrode 12 (made of SUS304, width 250 mm x length 50 mm x thickness 20 mm, solid dielectric : alumina) were arranged at intervals of 1 mm (plasma space P). Further, an opposite flat plate 21 (made of SUS304, width 250 mm x length 50 mm x thickness 20 mm) was arranged at intervals of 1 mm with respect to the ground electrode 12 to form a gas passing path 20.

### [Processing conditions]

Reactive gas: O₂ = 5SLM
Raw gas: TEOS = 0.2 g/min, N₂ = 10SLM
Substrate: Si wafer (8 inch)
Distance between substrate and electrode = 4 mm
Applied field: pulse field of 5 kHz, 15 kV (pulse width 10 µs)
Carrying speed of substrate: 200 mm/min
Substrate temperature: 350 °C

A film was formed on the surface of the substrate S under the apparatus structure and conditions described above, then a SiO₂ film having a film thickness of 1000 Å (film forming speed = 1000 Å/min) could be obtained.

### <Embodiment 13>

In the oxide film forming apparatus of FIG. 18, the distance between the lower end surface of the opposite flat plate 23 and the substrate S was 0.5 mm, and the exhaust conductance by the exhaust mechanism 6 on the opposite flat plate 23 side was 1/4 with respect to the exhaust conductance by the exhaust mechanism 6 on the voltage applied electrode 2 side. Other structures and film forming conditions are the same as Embodiment 12, and a film was formed on the surface of the substrate S, then a SiO₂ film having a film thickness of 1000 Å (film forming speed = 1000 Å/min) could be obtained.

### <Embodiment 14>

In the oxide film forming apparatus of FIG. 19, voltage applied electrodes 11, 11 (made of SUS304, width 250 mm x length 50 mm x thickness 20 mm, solid dielectric : alumina) and ground electrodes 12, 12 (made of SUS304, width 250 mm x length 50 mm x thickness 20 mm, solid dielectric : alumina) were arranged at intervals of 1 mm (plasma spaces P1, P2). Further, two ground electrodes 12, 12 are arranged at intervals of 1 mm to form a gas passing path 20.

### [Processing conditions]

Reactive gas: O₂ = 10SLM (plasma space P1), O₂ = 10SLM (plasma space P2),
Raw gas: TEOS = 0.2 g/min, N₂ = 10SLM
Substrate: Si wafer (8 inch)
Distance between substrate and electrode = 4 mm
Applied field: pulse field of 5 kHz, 15 kV (pulse width 10 µs)
Carrying speed of substrate: 200 mm/min
Substrate temperature: 350 °C

A film was formed on the surface of the substrate S under the apparatus structure and conditions described above, then a SiO₂ film could be obtained at film forming speed of about 700 Å/min. Further, a film was formed with a discharge frequency of an applied field changed (0 to 6 kHz). The film forming results (a relation between a discharge frequency and a film forming speed) are shown in FIG. 22.

### <Comparative Example 5>

As shown in FIG. 21, an oxide film forming apparatus not provided with an exhaust mechanism was used. Other apparatus structures and film forming conditions are the same as Embodiment 12. A film was formed on the surface of the substrate S, then a SiO₂ film could be obtained at film forming speed of about 500 Å/min. Further, a film was formed with a discharge frequency of an applied field changed (0 to 5 kHz). The film forming results (a relation between a discharge frequency and a film forming speed) could be obtained as shown in FIG. 23.

### <Comparison between Embodiment 14 and Comparative Example 5 >

In Comparative Example 5 (conventional type oxide film forming apparatus), the limit of the film forming speed was about 500 Å/min, whereas in Embodiment 14 (the oxide film forming apparatus of FIG. 19), the film forming speed is increased to about 700 Å/min. Further, in Comparative Example 5, there appears phenomenon that when the discharge frequency is made higher, gaseous reaction progresses so much that the film forming speed lowers, but in Embodiment 14, such a phenomenon does not appear.

In Embodiment 14, it has been also found that when the concentration of the raw gas (metal-contained gas) is made higher, and the discharge conditions are optimized, the high film forming speed of 5000 to 10000 Å/min is obtained.

As described above, according to the present invention, the raw gas comprising a silicon-contained gas such as TMOS, MTMOS or the like and the reactive gas comprising an oxidizing gas such as the discharge processed O₂, N₂O or the like are mixed in the vicinity of the substrate surface. Therefore, the raw gas is used efficiently for the film forming reaction, and it is possible to prevent occurrence of adhesion to an electrode and impurities.

Therefore, also in the CVD method under the normal pressure, the oxide film which is excellent in the membranous and coverage property can be formed at fast film forming speed, and moreover the maintenance spacing can be extended.

Further, if the discharge processed H₂O or H₂O not discharge processed is added to a reactive gas comprising the raw gas comprising a silicon-contained gas such as TMOS, MTMOS or the like and the oxidizing gas such as the discharge processed O₂, N₂O or the like, the oxide film which is better in the membranous and coverage property can be formed at fast film forming speed in the CVD method under the normal pressure.

Further, when the joined gas of the reactive gas after passage of the plasma space and the raw gas is made to be a gas flow flowing along the surface to be processed of the substrate, time at which the joined gas is mixed and time required for reaction are secured, and since the reaction is carried out on the side close to the substrate, it is to be consumed to form a thin film preferentially.

Whereby, the film forming speed can be made higher without wasting the raw gas.

In the present invention, there are advantages that if TMOS or MTMOS is used as the raw material, handling of gases is easy as compared with a silane gas, and further, a boiling point of TMOS or MTMOS is lower than TEOS widely used in general so that vaporization is easy. Further, handling of H₂O as an additive is also easy. There is a further advantage that the film forming processing can be carried out without giving damage to the substrate since the substrate need not to be put into the field.

### INDUSTRIAL APPLICABILITY

The oxide film forming method and apparatus according to the present invention can be utilized effectively for forming a silicon oxide film (SiO₂) or the like on the surface of the substrate such as a silicon wafer, an electronic circuit substrate or the like.

## Claims

1. A method for forming an oxide film on the surface of a substrate by a CVD method under the pressure conditions close to the atmospheric pressure, the method comprising: using process gases of two components, a raw gas (A) and a reactive gas (B); discharge processing the process gas (B) out of the process gases (A) and (B) of two components; and joining the process gas (A) not discharge processed with said process gas (B) discharge processed in the vicinity of the surface of a substrate to mix them.

2. A method for forming an oxide film on the surface of a substrate by a CVD method under the pressure conditions close to the atmospheric pressure, the method comprising: using process gases of three components, a raw gas (A), a reactive gas (B) and a H₂O gas (C); discharge processing the process gas (B) out of the process gases (A) to (C) of three components; and joining the process gas (A) and process gas (C) not discharge processed with said process gas (B) discharge processed in the vicinity of the surface of a substrate to mix them.

3. A method for forming an oxide film on the surface of a substrate by a CVD method under the pressure conditions close to the atmospheric pressure, the method comprising: using process gases of three components, a raw gas (A), a reactive gas (B) and a H₂O gas (C); individually discharge processing the process gas (B) and process gas (C) out of the process gases (A) to (C) of three components; and joining the process gas (A) not discharge processed with said process gas (B) and process gas (C) discharge processed in the vicinity of the surface of a substrate to mix them.

4. A method for forming an oxide film on the surface of a substrate by a CVD method under the pressure conditions close to the atmospheric pressure, the method comprising: using process gases of three components, a raw gas (A), a reactive gas (B) and a H₂O gas (C); discharge processing a mixed gas having the process gas (B) and process gas (C) mixed out of the process gases (A) to (C) of three components; and joining the process gas (A) not discharge processed with said mixed gas discharge processed in the vicinity of the surface of a substrate to mix them.

5. A method for forming an oxide film on the surface of a substrate by a CVD method under the pressure conditions close to the atmospheric pressure, the method comprising: using process gases of three components, a raw gas (A), a reactive gas (B) and a H₂O gas (C); discharge processing the process gas (B) out of the process gases (A) to (C) of three components; and joining a mixed gas of the process gas (A) and process gas (C) not discharge processed with said process gas (B) discharge processed in the vicinity of the surface of a substrate to mix them.

6. An oxide film forming method according to any of Claims 15 to 19, wherein said raw gas (A) is a silicon-contained gas such as TMOS, MTMOS or the like.

7. An oxide film forming method according to any of Claims 15 to 20, wherein said reactive gas (B) is an oxidizing gas such as O₂, N₂O or the like.

8. An oxide film forming method according to any of Claims 15 to 21, further comprising a gas supply source for supplying a process gas called a phosphorus-contained gas such as TMP, TEP or the like and / or a boron-contained gas (D) such as TMB, TEB or the like, wherein the process gas (D) is mixed with the process gas (A) for use.

9. An oxide film forming method according to any of Claims 1 to 8 wherein said joined gas forms a gas flow flowing along the surface to be processed of a substrate.

10. An oxide film forming method according to Claim 9, wherein by an exhaust mechanism, exhaust control is carried out so that said joined gas forms a gas flow flowing along the surface to be processed of a substrate.

11. An oxide film forming method according to Claim 9 or 10, wherein the total flow rate of introductory flow rates of said raw gas and said reactive gas is approximately the same as the flow rate of the gas flow flowing along the surface to be processed of a substrate.

12. An apparatus for forming an oxide film on the surface of a substrate by a CVD method under the pressure conditions close to the atmospheric pressure, the apparatus comprising: a gas supply source for supplying process gases of two components, a raw gas (A) and a reactive gas (B), and a discharge processing section, wherein the process gas (B) out of the process gases (A) and (B) of two components is subjected to discharge processing by the discharge processing section; and the process gas (A) is joined, in the vicinity of the surface of a substrate, without discharge processing, with the process gas (B) discharge processed to mix them, in the discharge processing section.

13. An apparatus for forming an oxide film on the surface of a substrate by a CVD method under the pressure conditions close to the atmospheric pressure, the apparatus comprising: a gas supply source for supplying process gases of three components, a raw gas (A), a reactive gas (B) and a H₂O gas (C), and a discharge processing section, wherein the process gas (B) out of the process gases (A) to (C) of three components is subjected to discharge processing by the discharge processing section; and the process gas (A) and the process gas (C) are joined, in the vicinity of the surface of a substrate, without discharge processing, with the process gas (B) discharge processed to mix them.

14. An apparatus for forming an oxide film on the surface of a substrate by a CVD method under the pressure conditions close to the atmospheric pressure, the apparatus comprising: a gas supply source for supplying process gases of three components, a raw gas (A), a reactive gas (B) and a H₂O gas (C), and a discharge processing section, wherein the process gas (B) and process gas (C) out of the process gases (A) to (C) of three components are subjected to discharge processing in individual discharge processing section, and the process gas (A) is joined, without discharge processing, with said process gas (B) and process gas (C) discharge processed in the vicinity of the surface of a substrate to mix them.

15. An apparatus for forming an oxide film on the surface of a substrate by a CVD method under the pressure conditions close to the atmospheric pressure, the apparatus comprising: a gas supply source for supplying process gases of three components, a raw gas (A), a reactive gas (B) and a H₂O gas (C), and a discharge processing section, wherein a mixed gas having the process gas (B) and process gas (C) mixed out of the process gases (A) to (C) of three components is subjected to discharge processing by the discharge processing section; and the process gas (A) is joined, in the vicinity of the surface of a substrate, without discharge processing, with the mixed gas discharge processed to mix them.

16. An apparatus for forming an oxide film on the surface of a substrate by a CVD method under the pressure conditions close to the atmospheric pressure, the apparatus comprising: a gas supply source for supplying process gases of of three components, a raw gas (A), a reactive gas (B) and a H₂O gas (C), and a discharge processing section, wherein the process gas (B) out of the process gases (A) to (C) of three components is subjected to discharge processing in the discharge processing section; and the mixed gas of the process gas (A) and the process gas (C) is joined, in the vicinity of the surface of a substrate, without discharge processing, with the process gas (B) discharge processed to mix them.

17. An oxide film forming apparatus according to any of Claims 12 to 16, wherein said raw gas (A) is a silicon-contained gas such as TMOS, MTMOS or the like.

18. An oxide film forming apparatus according to any of Claims 12 to 17, wherein said reactive gas (B) is an oxidizing gas such as O₂, N₂O or the like.

19. An oxide film forming apparatus according to any of Claims 12 to 18, wherein the quantity of said process gas (B) out of the process gases used in the CVD method is in excess of 50 weight % of the whole process gas, and the weight ratio between said process gas (A) and said process gas (C) [process gas (A) / process gas (C)] is 1/100 to 1/0.02.

20. An oxide film forming apparatus according to any of Claims 12 to 19, wherein the supplying total of process gases of said three components is 1 to 300 SLM.

21. An oxide film forming apparatus according to any of Claims 12 to 20, further comprising a gas supply source for supplying a process gas called a phosphorus-contained gas such as TMP, TEP or the like and / or a boron-contained gas (D) such as TMB, TEB or the like, wherein the process gas (D) is mixed with the process gas (A) for use.

22. An oxide film forming apparatus according to any of Claims 12 to 21, wherein the distance between said discharge processing section and the surface of a substrate placed on a substrate place section is 0.5 to 30 mm.

23. An oxide film forming apparatus according to any of Claims 12 to 22, wherein the substrate place section for placing the substrate and said discharge processing section are moved relatively in one direction or in both directions whereby the substrate can be carried one way or return relatively, a gas emitting port of the process gas not discharge processed is arranged in the midst of the substrate carrying course, and gas emitting ports of the process gas discharged processed are arranged forward and backward with respect to the substrate carrying direction of said first mentioned gas emitting port.

24. An oxide film forming apparatus according to Claim 23, wherein the process gas discharge processed emitted from said gas emitting ports arranged forward and backward with respect to the substrate carrying direction is the same process gas.

25. An oxide film forming apparatus according to Claims 12 to 24, comprising an exhaust mechanism for exhaust controlling the direction in which a joined gas of said reactive gas and said raw gas flows.

26. An oxide film forming apparatus according to Claim 25, wherein said exhaust mechanism is arranged on the side close to the plasma space on the side at a distance of a flow passage of the joined gas from a place where said reactive gas and said raw gas are joined.

27. An oxide film forming apparatus according to Claim 25, wherein said exhaust mechanisms are arranged on both sides of said joined place, and the conductance of the flow passage on the side close to the plasma space, out of the joined gas flow passages from the joined place to the exhaust mechanism, is small.

28. An oxide film forming apparatus according to any of Claims 25 to 27, wherein there is provided a gas flow regulating plate for forming a joining gas flow passage along the surface to be processed.

29. An oxide film forming apparatus according to Claim 28, wherein a ceramic porous gas flow regulating plate is provided, and an inert gas is emitted from said gas flow regulating plate.
